# EUROPEAN PATENT APPLICATION

(11) **EP 4 797 312 A1**
(43) Date of publication of application: **26.08.2026**
(21) Application number: 24880127.6
(22) Date of filing: 17.10.2024
(51) Int. Cl.: H01J 37/32, H05H 1/46

(54) **PLASMA INDUCTION DEVICE COMPRISING OFFSET COIL**

(30) Priority: 20.10.2023 KR 20230141130
(71) Applicant: EN2CORE technology, Inc, Daejeon 34127 (KR)
(72) Inventor: HUH, Jin, Daejeon 34032 (KR); SOHN, Yeonghoon, Daejeon 34050 (KR); THAI, Xuan Van, Daejeon 34007 (KR); CHOI, Byeongguk, Daejeon 34127 (KR); LEE, Jongho, Daejeon 34049 (KR); CHAE, Dae-Seok, Daejeon 34904 (KR)
(74) Representative: Kim Kang, Jae Hee
(86) International application number: PCT/KR2024/015720
(87) International publication number: WO 2025/084790

(57) **Abstract**

A plasma induction device for inducing plasma is disclosed. Particularly, the plasma induction device may comprises: adischarge tube which provides an induction space for plasma, and which has an inlet for injecting gas and an outlet through which the gas is processed and discharged; an ignition antenna which is electrically wound in a first winding direction on the basis of the central axis of the discharge tube, and which is for igniting the plasma in the discharge tube; a maintaining antenna, which is electrically wound in the same direction as the first winding direction on the basis of the central axis of the discharge tube, is arranged to be physically spaced apart from the ignition antenna, and forms an electric field for maintaining the plasma in the discharge tube; a first canceling coil electrically wound in a second winding direction on the basis of the virtual central axis; and a second canceling coil which is arranged to be physically spaced apart from the first canceling coil, and which is electrically wound, on the basis of the virtual central axis, in a direction that differs from the second winding direction.

## Description

### Technical Field

The present disclosure relates to a plasma inducing apparatus including a canceling coil. More particularly, the present disclosure relates to a plasma inducing apparatus for inducing plasma inside a discharging tube by using a plurality of antennas, wherein the plasma inducing apparatus includes one or more canceling coils for canceling an induced current caused by a magnetic field generated by one antenna, in order to minimize functional influence of the magnetic field on another antenna.

### Background Art

Plasma process technologies utilizing plasma have been used in various industrial fields, including semiconductor, display, and medical device technology fields as well as environmental technology fields such as air, water, and soil purification, and energy technology fields such as solar cells and hydrogen energy, and among the plasma process technologies, research on inductively coupled discharge for forming high-density plasma with low power has been widely conducted.

In the meantime, in a plasma inducing apparatus using inductively coupled discharge, an ignition antenna to which high voltage is applied to ignite plasma and a maintaining antenna for inducing and maintaining the ignited plasma may be used. Herein, a relatively high voltage is applied to the ignition antenna, and there is a problem in that the maintaining antenna is affected by a magnetic field generated by the ignition antenna.

Conversely, when voltage is not applied to the ignition antenna, there is a problem in that the ignition antenna is affected by a magnetic field generated by the voltage applied to the maintaining antenna.

Such an electromagnetic field between the antennas may cause damage or abnormal operation of the plasma inducing apparatus, and the present disclosure proposes a method of providing a separate coil in order to minimize electromagnetic field influence between the antennas.

### Disclosure

### Technical Problem

The problem to be solved in present disclosure is to provide a plasma inducing apparatus in which influence of a magnetic field generated between antennas is minimized.

The problem to be solved in present disclosure is to provide at least one canceling coil that cancels an induced current of a maintaining antenna or an ignition antenna generated by a magnetic field generated from the ignition antenna or the maintaining antenna in a plasma inducing apparatus.

The problem to be solved in present disclosure is to provide at least one canceling antenna that generates an induced current in a direction opposite to an induced current occurring in a maintaining antenna or an ignition antenna by the ignition antenna or the maintaining antenna in the plasma inducing apparatus.

Technical solutions of the present disclosure may not be limited to the above, and other technical solutions which are not described herein should be clearly understood by those skilled in the art, to which the present disclosure belongs, from the present specification and the accompanying drawings.

### Technical Solution

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the first end and the sixth end, and the sixth end is electrically interposed between the second end and the fifth end; and a second canceling coil electrically wounded as a different direction with the second wounding direction with respect to the virtual central axis, and disposed physically spaced apart from the first canceling coil, wherein the second canceling coil has a seventh end and an eighth end, the seventh end is electrically interposed between the third end and the eighth end, and the eighth end is electrically interposed between the seventh end and the fourth end.

At that time, each of the first canceling coil and the second canceling coil may have an inductance value allowing that a difference between a first mutual inductance value between the ignition antenna and the maintaining antenna and a second mutual inductance between the first canceling coil and the second canceling coil is equal to or lower than a first threshold value.

Furthermore, each of the first canceling coil and the second canceling coil may have an inductance value allowing that a first mutual inductance value between the ignition antenna the maintaining antenna is identical to a second mutual inductance between the first canceling coil and the second canceling coil.

Furthermore, the first canceling coil and the second canceling coil may be physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to or lower than a second threshold value.

Furthermore, the first canceling coil and the second canceling coil may be physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to 0.

Furthermore, the plasma inducing apparatus may further comprise a first Radio Frequency (RF) generator electrically interposed between the ignition antenna and the first canceling coil, and configured to supply a first AC voltage to the ignition antenna and the first canceling coil; and a second RF generator electrically interposed between the maintaining antenna and the second canceling coil, and configured to supply a second AC voltage to the maintaining antenna and the second canceling coil.

Furthermore, the plasma inducing apparatus may further comprise a first equivalent capacitor, wherein the first equivalent capacitor may be determined by at least one ignition capacitor interposed between the first RF generator and the ignition antenna; and a first compensation capacitor, wherein the first compensation capacitor may be interposed between the ignition antenna and the first canceling coil, wherein the capacitance value of the first compensation capacitor may allow that a difference between a first resonant frequency according to the ignition antenna and the first equivalent capacitor and a second resonant frequency according to the first canceling coil and the first compensation capacitor is equal to or lower than a first value.

Furthermore, the plasma inducing apparatus may further comprise a first equivalent capacitor, wherein the first equivalent capacitor may be determined by at least one ignition capacitor interposed between the first RF generator and the ignition antenna; and a first compensation capacitor, wherein the first compensation capacitor interposed between the ignition antenna and the first canceling coil, wherein the capacitance value of the first compensation capacitor may allow that a first resonant frequency according to the ignition antenna and the first equivalent capacitor may be identical to a second resonant frequency according to the first canceling coil and the first compensation capacitor.

Furthermore, the plasma inducing apparatus may further comprise a second equivalent capacitor, wherein the second equivalent capacitor may be determined by at least one maintaining capacitor interposed between the second RF generator and the maintaining antenna and at least one auxiliary capacitor included within the maintaining antenna; and a second compensation capacitor interposed between the maintaining antenna and the second canceling coil, wherein the capacitance value of the second compensation capacitor may allow that a difference between a third resonant frequency according to the maintaining antenna and the second equivalent capacitor and a fourth resonant frequency according to the second canceling coil and the second compensation capacitor is equal to or lower than a second value.

Furthermore, the plasma inducing apparatus may further comprise a second equivalent capacitor, wherein the second equivalent capacitor may be determined by at least one maintaining capacitor interposed between the second RF generator and the maintaining antenna and at least one auxiliary capacitor included within the maintaining antenna; and a second compensation capacitor interposed between the maintaining antenna and the second canceling coil, wherein the capacitance value of the second compensation capacitor may allow that a third resonant frequency according to the maintaining antenna and the second equivalent capacitor may be identical to a fourth resonant frequency according to the second canceling coil and the second compensation capacitor is equal to or lower than a second value.

Furthermore, the plasma inducing apparatus may be configured to control the second RF generator not to supply the second AC voltage while controlling the first RF generator to supply the first AC voltage, or configured to control the first RF generator not to supply the first AC voltage while controlling the second RF generator to supply the second AC voltage.

Furthermore, the plasma inducing apparatus may be configured to control the second RF generator to supply the second AC voltage while controlling the first RF generator to supply the first AC voltage.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the first end and the sixth end, and the sixth end is electrically interposed between the second end and the fifth end; anda second canceling coil electrically wounded as the same direction with the second wounding direction with respect to the virtual central axis, and disposed physically spaced apart from the first canceling coil, wherein the second canceling coil has a seventh end and an eighth end, the seventh end is electrically interposed between the fourth end and the eighth end, and the eighth end is electrically interposed between the seventh end and the third end.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the second end and the sixth end, and the sixth end is electrically interposed between the first end and the fifth end; and a second canceling coil electrically wounded as a different direction with the second wounding direction with respect to the virtual central axis, and disposed physically spaced apart from the first canceling coil, wherein the second canceling coil has a seventh end and an eighth end, the seventh end is electrically interposed between the fourth end and the eighth end, and the eighth end is electrically interposed between the seventh end and the third end.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the second end and the sixth end, and the sixth end is electrically interposed between the first end and the fifth end; and a second canceling coil electrically wounded as the same direction with the second wounding direction with respect to the virtual central axis, and disposed physically spaced apart from the first canceling coil, wherein the second canceling coil has a seventh end and an eighth end, the seventh end is electrically interposed between the third end and the eighth end, and the eighth end is electrically interposed between the seventh end and the fourth end.

### Advantageous Effects

According to an embodiment of the present disclosure, an induced electromotive force can be prevented from being unnecessarily applied to and an induced current can be prevented from flowing unnecessarily through the ignition antenna structure or the maintaining antenna structure in the plasma inducing apparatus.

According to an embodiment of the present disclosure, system stability can be improved because damage to or malfunction of a power source supplying power to the antenna structure in the plasma inducing apparatus is prevented.

According to an embodiment of the present disclosure, an induced electromotive force and an induced current generated in the maintaining antenna or the ignition antenna due to the magnetic field generated by the ignition antenna structure or the maintaining antenna structure in the plasma inducing apparatus can be minimized.

Effects of the present disclosure may not be limited to the above, and other effects which are not described herein should be clearly understood by those skilled in the art, to which the present disclosure belongs, from the present specification and the accompanying drawings.

### Description of Drawings

FIG. 1 is a diagram illustrating a plasma inducing apparatus according to an embodiment.
FIG. 2 is a diagram illustrating a radio frequency (RF) generator according to an embodiment.
FIG. 3 is a diagram illustrating an antenna structure according to an embodiment.
FIG. 4 is a diagram illustrating a maintaining antenna according to an embodiment.
FIG. 5 is a diagram illustrating a maintaining antenna according to another embodiment.
FIG. 6 is a diagram illustrating a process in which plasma is induced according to an embodiment of the present disclosure.
FIGS. 7 to 8 are diagrams illustrating a process in which an induced electromotive force is generated in an ignition antenna structure or a maintaining antenna structure by the other antenna structure according to an embodiment of the present disclosure.
FIGS. 9 to 10 are diagrams illustrating a structure in which a canceling coil is connected to an antenna structure and an RF generator according to an embodiment of the present disclosure.
FIGS. 11 to 20 are diagrams illustrating cancellation of an induced current by a canceling coil according to various embodiments of the present disclosure.
FIG. 21 is a diagram illustrating ignition capacitors connected to an ignition antenna according to an embodiment.
FIG. 22 is a diagram illustrating maintaining capacitors connected to a maintaining antenna according to an embodiment.
FIGS. 23 to 24 are diagrams illustrating a method of compensating for a resonant frequency of an ignition antenna structure and/or a maintaining antenna structure varied by a canceling coil.

### Mode for Invention

The above-described objectives, characteristics, and advantages of the present disclosure will be more apparent by the following detailed description with reference to the accompanying drawings. Since the present disclosure may be variously modified and have various embodiments, specific embodiments will be shown in the accompanying drawings and described in detail in a detailed description.

Embodiments described in this specification are made to clearly explain the scope of the present disclosure to those having ordinary skill in the art and are not intended to limit the present disclosure. It should be interpreted that the present disclosure may include substitutions and modifications within the technical scope of the present disclosure.

The accompanying drawings are to facilitate the explanation of the present disclosure and the shape in the drawings may be exaggerated for the purpose of convenience of explanation, so the present disclosure should not be limited to the drawings.

Moreover, detailed descriptions about well-known functions or configurations associated with the present disclosure will be ruled out in order to not unnecessarily obscure the essence of the present disclosure. It should also be noted that, although ordinal numbers (such as first and second) are used in the following description, they are used only to distinguish similar components.

In addition, the terms "module", "unit", and "parts" for elements used in the following description are given or used interchangeably only for facilitation of preparing this specification, and thus they are not granted a specific meaning or function.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the first end and the sixth end, and the sixth end is electrically interposed between the second end and the fifth end; and a second canceling coil electrically wounded as a different direction with the second wounding direction with respect to the virtual central axis, and disposed physically spaced apart from the first canceling coil, wherein the second canceling coil has a seventh end and an eighth end, the seventh end is electrically interposed between the third end and the eighth end, and the eighth end is electrically interposed between the seventh end and the fourth end.

At that time, each of the first canceling coil and the second canceling coil may have an inductance value allowing that a difference between a first mutual inductance value between the ignition antenna and the maintaining antenna and a second mutual inductance between the first canceling coil and the second canceling coil is equal to or lower than a first threshold value.

Furthermore, each of the first canceling coil and the second canceling coil may have an inductance value allowing that a first mutual inductance value between the ignition antenna the maintaining antenna is identical to a second mutual inductance between the first canceling coil and the second canceling coil.

Furthermore, the first canceling coil and the second canceling coil may be physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to or lower than a second threshold value.

Furthermore, the first canceling coil and the second canceling coil may be physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to 0.

Furthermore, the plasma inducing apparatus may further comprise a first Radio Frequency (RF) generator electrically interposed between the ignition antenna and the first canceling coil, and configured to supply a first AC voltage to the ignition antenna and the first canceling coil; and a second RF generator electrically interposed between the maintaining antenna and the second canceling coil, and configured to supply a second AC voltage to the maintaining antenna and the second canceling coil.

Furthermore, the plasma inducing apparatus may further comprise a first equivalent capacitor, wherein the first equivalent capacitor may be determined by at least one ignition capacitor interposed between the first RF generator and the ignition antenna; and a first compensation capacitor, wherein the first compensation capacitor may be interposed between the ignition antenna and the first canceling coil, wherein the capacitance value of the first compensation capacitor may allow that a difference between a first resonant frequency according to the ignition antenna and the first equivalent capacitor and a second resonant frequency according to the first canceling coil and the first compensation capacitor is equal to or lower than a first value.

Furthermore, the plasma inducing apparatus may further comprise a first equivalent capacitor, wherein the first equivalent capacitor may be determined by at least one ignition capacitor interposed between the first RF generator and the ignition antenna; and a first compensation capacitor, wherein the first compensation capacitor interposed between the ignition antenna and the first canceling coil, wherein the capacitance value of the first compensation capacitor may allow that a first resonant frequency according to the ignition antenna and the first equivalent capacitor may be identical to a second resonant frequency according to the first canceling coil and the first compensation capacitor.

Furthermore, the plasma inducing apparatus may further comprise a second equivalent capacitor, wherein the second equivalent capacitor may be determined by at least one maintaining capacitor interposed between the second RF generator and the maintaining antenna and at least one auxiliary capacitor included within the maintaining antenna; and a second compensation capacitor interposed between the maintaining antenna and the second canceling coil, wherein the capacitance value of the second compensation capacitor may allow that a difference between a third resonant frequency according to the maintaining antenna and the second equivalent capacitor and a fourth resonant frequency according to the second canceling coil and the second compensation capacitor is equal to or lower than a second value.

Furthermore, the plasma inducing apparatus may further comprise a second equivalent capacitor, wherein the second equivalent capacitor may be determined by at least one maintaining capacitor interposed between the second RF generator and the maintaining antenna and at least one auxiliary capacitor included within the maintaining antenna; and a second compensation capacitor interposed between the maintaining antenna and the second canceling coil, wherein the capacitance value of the second compensation capacitor may allow that a third resonant frequency according to the maintaining antenna and the second equivalent capacitor may be identical to a fourth resonant frequency according to the second canceling coil and the second compensation capacitor is equal to or lower than a second value.

Furthermore, the plasma inducing apparatus may be configured to control the second RF generator not to supply the second AC voltage while controlling the first RF generator to supply the first AC voltage, or configured to control the first RF generator not to supply the first AC voltage while controlling the second RF generator to supply the second AC voltage.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the first end and the sixth end, and the sixth end is electrically interposed between the second end and the fifth end; anda second canceling coil electrically wounded as the same direction with the second wounding direction with respect to the virtual central axis, and disposed physically spaced apart from the first canceling coil, wherein the second canceling coil has a seventh end and an eighth end, the seventh end is electrically interposed between the fourth end and the eighth end, and the eighth end is electrically interposed between the seventh end and the third end.

At that time, each of the first canceling coil and the second canceling coil may have an inductance value allowing that a difference between a first mutual inductance value between the ignition antenna and the maintaining antenna and a second mutual inductance between the first canceling coil and the second canceling coil is equal to or lower than a first threshold value.

Furthermore, each of the first canceling coil and the second canceling coil may have an inductance value allowing that a first mutual inductance value between the ignition antenna the maintaining antenna is identical to a second mutual inductance between the first canceling coil and the second canceling coil.

Furthermore, the first canceling coil and the second canceling coil may be physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to or lower than a second threshold value.

Furthermore, the first canceling coil and the second canceling coil may be physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to 0.

Furthermore, the plasma inducing apparatus may further comprise a first Radio Frequency (RF) generator electrically interposed between the ignition antenna and the first canceling coil, and configured to supply a first AC voltage to the ignition antenna and the first canceling coil; and a second RF generator electrically interposed between the maintaining antenna and the second canceling coil, and configured to supply a second AC voltage to the maintaining antenna and the second canceling coil.

Furthermore, the plasma inducing apparatus may further comprise a first equivalent capacitor, wherein the first equivalent capacitor may be determined by at least one ignition capacitor interposed between the first RF generator and the ignition antenna; and a first compensation capacitor, wherein the first compensation capacitor may be interposed between the ignition antenna and the first canceling coil, wherein the capacitance value of the first compensation capacitor may allow that a difference between a first resonant frequency according to the ignition antenna and the first equivalent capacitor and a second resonant frequency according to the first canceling coil and the first compensation capacitor is equal to or lower than a first value.

Furthermore, the plasma inducing apparatus may further comprise a first equivalent capacitor, wherein the first equivalent capacitor may be determined by at least one ignition capacitor interposed between the first RF generator and the ignition antenna; and a first compensation capacitor, wherein the first compensation capacitor interposed between the ignition antenna and the first canceling coil, wherein the capacitance value of the first compensation capacitor may allow that a first resonant frequency according to the ignition antenna and the first equivalent capacitor may be identical to a second resonant frequency according to the first canceling coil and the first compensation capacitor.

Furthermore, the plasma inducing apparatus may further comprise a second equivalent capacitor, wherein the second equivalent capacitor may be determined by at least one maintaining capacitor interposed between the second RF generator and the maintaining antenna and at least one auxiliary capacitor included within the maintaining antenna; and a second compensation capacitor interposed between the maintaining antenna and the second canceling coil, wherein the capacitance value of the second compensation capacitor may allow that a difference between a third resonant frequency according to the maintaining antenna and the second equivalent capacitor and a fourth resonant frequency according to the second canceling coil and the second compensation capacitor is equal to or lower than a second value.

Furthermore, the plasma inducing apparatus may further comprise a second equivalent capacitor, wherein the second equivalent capacitor may be determined by at least one maintaining capacitor interposed between the second RF generator and the maintaining antenna and at least one auxiliary capacitor included within the maintaining antenna; and a second compensation capacitor interposed between the maintaining antenna and the second canceling coil, wherein the capacitance value of the second compensation capacitor may allow that a third resonant frequency according to the maintaining antenna and the second equivalent capacitor may be identical to a fourth resonant frequency according to the second canceling coil and the second compensation capacitor is equal to or lower than a second value.

Furthermore, the plasma inducing apparatus may be configured to control the second RF generator not to supply the second AC voltage while controlling the first RF generator to supply the first AC voltage, or configured to control the first RF generator not to supply the first AC voltage while controlling the second RF generator to supply the second AC voltage.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the second end and the sixth end, and the sixth end is electrically interposed between the first end and the fifth end; and a second canceling coil electrically wounded as a different direction with the second wounding direction with respect to the virtual central axis, and disposed physically spaced apart from the first canceling coil, wherein the second canceling coil has a seventh end and an eighth end, the seventh end is electrically interposed between the fourth end and the eighth end, and the eighth end is electrically interposed between the seventh end and the third end.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as the same direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the second end and the sixth end, and the sixth end is electrically interposed between the first end and the fifth end; and a second canceling coil electrically wounded as the same direction with the second wounding direction with respect to the virtual central axis, and disposed physically spaced apart from the first canceling coil, wherein the second canceling coil has a seventh end and an eighth end, the seventh end is electrically interposed between the third end and the eighth end, and the eighth end is electrically interposed between the seventh end and the fourth end.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as a different direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the first end and the sixth end, and the sixth end is electrically interposed between the second end and the fifth end; and a second canceling coil electrically wounded as the same direction with the second wounding direction with respect to the virtual central axis, and disposed physically spaced apart from the first canceling coil, wherein the second canceling coil has a seventh end and an eighth end, the seventh end is electrically interposed between the third end and the eighth end, and the eighth end is electrically interposed between the seventh end and the fourth end.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as a different direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the second end and the sixth end, and the sixth end is electrically interposed between the first end and the fifth end; and a second canceling coil electrically wounded as the same direction with the second wounding direction with respect to the virtual central axis, and disposed physically spaced apart from the first canceling coil, wherein the second canceling coil has a seventh end and an eighth end, the seventh end is electrically interposed between the fourth end and the eighth end, and the eighth end is electrically interposed between the seventh end and the third end.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as a different direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the second end and the sixth end, and the sixth end is electrically interposed between the first end and the fifth end; and a second canceling coil electrically wounded as a different direction with the second wounding direction with respect to the virtual central axis, and disposed physically spaced apart from the first canceling coil, wherein the second canceling coil has a seventh end and an eighth end, the seventh end is electrically interposed between the third end and the eighth end, and the eighth end is electrically interposed between the seventh end and the fourth end.

A plasma inducing apparatus for inducing a plasma according to an embodiment of the present disclosure may comprise a discharging tube providing an induction space of the plasma and having an inlet for introducing a gas and an outlet through which the gas is processed and discharged; an ignition antenna electrically wounded as a first wounding direction with respect to a central axis of the discharging tube and for igniting the plasma within the discharging tube, wherein the ignition antenna has a first end and a second end, the first end is closer to the inlet to the second end; a maintaining antenna electrically wounded as a different direction with a first wounding direction with respect to the central axis of the discharging tube, disposed physically spaced apart from the ignition antenna and forming electric field for maintain the plasma within the discharging tube, wherein the maintaining antenna has a third end and a fourth end, the third end is closer to the second end than the fourth end and the fourth end is closer to the outlet than the third end; a first canceling coil electrically wounded as a second wounding direction with respect to a virtual central axis, wherein the first canceling coil has a fifth end and a sixth end, the fifth end is electrically interposed between the first end and the sixth end, and the sixth end is electrically interposed between the second end and the fifth end; and a second canceling coil electrically wounded as a different direction with the second wounding direction with respect to the virtual central axis, and disposed physically spaced apart from the first canceling coil, wherein the second canceling coil has a seventh end and an eighth end, the seventh end is electrically interposed between the fourth end and the eighth end, and the eighth end is electrically interposed between the seventh end and the third end.

A plasma inducing apparatus for inducing a plasma according to an embodiment of the present disclosure may comprise a discharging tube providing an induction space of the plasma; an ignition antenna disposed to adjacent of the discharging tube; a maintaining antenna disposed, around the discharging tube, physically spaced apart from the ignition antenna and forming electric field for maintain the plasma within the discharging tube, a first canceling coil disposed with respect to a virtual central axis and electrically interposed between the ignition antenna and a first Radio Frequency (RF) generator; and a second canceling coil disposed with respect to the virtual central axis and electrically interposed between the maintaining antenna and a second RF generator, wherein the first canceling coil and the second canceling coil are disposed such that a direction of a first induced current of the first canceling coil generated according to a first mutual inductance is opposite to a direction of a second induced voltage of the ignition antenna generated according to a second mutual inductance, while a direction of a third induced current of the second canceling coil generated according to the first mutual inductance is opposite to a direction of a fourth induced current of the maintaining antenna generated according to the second mutual inductance, wherein the first mutual inductance is mutual inductance between the first canceling coil and the second canceling coil, and wherein the second mutual inductance is mutual inductance between the ignition antenna and the maintaining antenna.

### [Definition of terms]

The present disclosure relates to a plasma inducing apparatus for inducing plasma. More particularly, stability and durability can be increased by preventing damage to or malfunction of a plasma inducing apparatus caused by an induced current generated from a plurality of antennas disposed in a plasma inducing apparatus for a plasma process.

In the present disclosure, a plasma process refers to a process of generating and using plasma, and is used in semiconductor processes, display processes, nano processes, and environmental improvement. In the present disclosure, for convenience of description, semiconductor processes such as plasma ashing, plasma chemical vapor deposition (CVD), plasma etching, sputtering, and surface modification are described as main embodiments of plasma processes, but the technical idea of the present disclosure is not limited thereto.

Plasma is a phase in which a material is separated into electrons having negative charges and ions having positive charges by application of high energy, and may be induced or generated by various methods.

There are many methods for generating plasma. Among them, inductively coupled plasma (ICP) refers to plasma induced by supplying power to a coil or an antenna and forming an induced electric field or a capacitive electric field in a particular space, and may generally be driven by a high-frequency power source such as radio frequency (RF).

An antenna structure may refer to an object that includes the above-described antenna and forms an induced electric field or a capacitive electric field for generating plasma by receiving power. The antenna structure may be variously designed according to the purpose and specifications of a plasma inducing system, and the shape or structure of the antenna structure may significantly affect efficiency or durability of the plasma inducing system.

### [Plasma inducing apparatus]

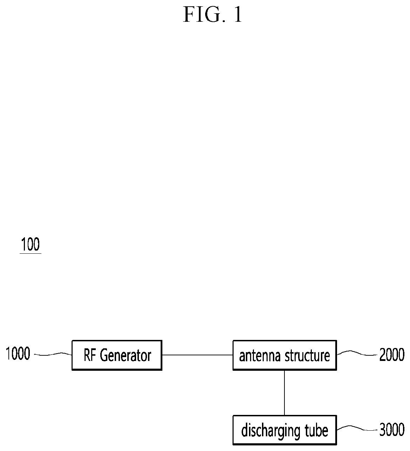

Hereinafter, a plasma inducing apparatus and its configuration will be described with reference to FIG. 1.

FIG. 1 is a diagram illustrating a plasma inducing apparatus 100 according to an embodiment.

Referring to FIG. 1, the plasma inducing apparatus 100 may include an RF generator 1000, an antenna structure 2000, and a discharging tube 3000.

The RF generator 1000 may provide power to the antenna structure 2000. For example, the RF generator 1000 may apply AC power having a particular driving frequency to the antenna structure 2000. Herein, AC power may be understood to refer to AC current or AC voltage.

The RF generator 1000 may monitor impedance of the antenna structure 2000 and/or power applied to the antenna structure 2000. Specifically, the RF generator 1000 may obtain information on current flowing through the antenna structure 2000 or voltage as described later.

The RF generator 1000 may change a driving frequency of AC power provided to the antenna structure 2000. The RF generator 1000 may change a driving frequency of provided AC power on the basis of impedance of the antenna structure 2000 and/or power applied to the antenna structure 2000.

The antenna structure 2000 may be electrically connected to the RF generator 1000. For example, one end of the RF generator 1000 may be electrically connected to one end of the antenna structure 2000, and other end of the RF generator 1000 may be electrically connected to other end of the antenna structure 2000. The RF generator 1000 may be connected to the antenna structure 2000 through a separate electrical element.

In the present disclosure, one end or other end refers to an end portion of an object, but is not limited to referring only to an end point of the object or necessarily including the end point. For example, electrical connection between the one end of the antenna structure 2000 and the one end of the RF generator 1000 may refer to a case in which any one end point of the antenna structure 200 or a portion adjacent to the end point is connected to one terminal of the RF generator 1000 through a conductor such as a conductive wire. In addition, one end or other end may refer to an end portion of any one part of an object, which may be understood as an end point of the part, a portion including the end point, or a portion spaced apart from the end point by a predetermined distance.

As described above, one end or other end is an expression for indicating one portion of an object, and the expression itself does not limit a structure or property of the object, or a connection relationship between objects. For example, as described later, when the antenna structure 2000 comprises a plurality of antenna segments and one end of any one antenna segment is connected to other end of another one antenna segment, the two antenna segments may be implemented as an integrated form or as physically separated forms.

The antenna structure 2000 may form an electromagnetic field inside the discharging tube 3000 to induce plasma generation. For example, the antenna structure 2000 may receive power from the RF generator 1000 to form an electromagnetic field inside the discharging tube 3000 and induce plasma generation. More specifically, an electromagnetic field formed inside the discharging tube 3000 by the antenna structure 2000 periodically changes its direction due to the AC power supplied by the RF generator 1000, and a gas supplied into the discharging tube 3000 receives energy from the periodically changing electromagnetic field and is subjected to phase transition into plasma.

The antenna structure 2000 may basically have a ring shape or a coil-like shape that surrounds an outer surface of the discharging tube (or a dielectric tube).

However, in order to achieve objectives which are generating plasma and maintaining plasma density even when high frequency and high power for plasma formation are supplied to the antenna structure, the antenna structure may have a specially engineered structure.

The antenna structure 2000 may have a layered structure. For example, the antenna structure may have a structure in which identical or very similar structures are stacked in a length direction of the discharging tube (or dielectric tube).

One layer of the antenna structure 2000 may comprise a plurality of turns. For example, one layer of the antenna structure 2000 may comprise at least one turn. For example, one layer of the antenna structure 2000 may comprise one, two, three, or more turns.

The antenna structure 2000 may include at least one capacitive element. For example, the plurality of antennas constituting the antenna structure 2000 may be electrically connected by the capacitive element. In addition, the antenna structure 2000 may further include a capacitive element for connection with the RF generator 1000.

In the meantime, a capacitive element described in the present disclosure may refer to a condenser, a capacitor, a multilayer ceramic capacitor, an ultracapacitor, or an equivalent circuit of a capacitive element having a function of storing electrical energy.

The discharging tube 3000 may create an environment for inducing plasma. For example, the discharging tube 3000 may define an internal space in which plasma is induced.

The discharging tube 3000 may provide a space in which plasma generation is induced. The discharging tube 3000 may have a pipe shape (or a hollow cylindrical shape). However, the shape of the discharging tube 3000 is not limited to a pipe shape, and any shape including an internal space for generating plasma is sufficient.

Gas (e.g., NF3, Ar, CO2, CH4, O2, He, and/or H2) for generating plasma may flow into the discharging tube 3000. For example, the discharging tube 3000 may be fluidly connected to at least one gas storage part, and a gas may flow from the gas storage part into the discharging tube 3000 through a mass flow controller (MFC).

The discharging tube 3000 may be made of various materials. For example, the discharging tube 3000 may be manufactured of a non-conductive material or a material having high thermal conductivity. Specifically, the discharging tube 3000 may be manufactured of aluminum nitride (AlN), aluminum oxide (Al2O3), silicon nitride (SiN), silicon nitride (Si3N4), silicon dioxide (SiO2), yttrium oxide (Y2O3), or silicon carbide (SiC). Furthermore, the discharging tube(3000) may be manufactured of a material that does not generate impurities (particles) by reacting with a gas flowing into the discharging tube 3000 to induce plasma.

The discharging tube 3000 may be fluidly connected to a process chamber. Herein, the process chamber may be understood as a chamber that defines a space in which a plasma process is performed and into which products (e.g., active species) generated in the discharging tube 3000 flow. For example, the discharging tube 3000 and the process chamber may be connected through a conduit, and fluid may move from the discharging tube 3000 to the process chamber through the conduit.

An internal environment of the discharging tube 3000 may be controlled. Specifically, for plasma induction, the temperature or pressure inside the discharging tube 3000 may be controlled to have an appropriate value or to be maintained within a predetermined range. To this end, the discharging tube 3000 may include a temperature adjustment part such as a heating wire or a thermoelectric element. In addition, the discharging tube 3000 may include a gas outlet for controlling internal pressure.

Hereinafter, the RF generator 1000 and the antenna structure 2000 described above will be described in more detail.

### [RF generator]

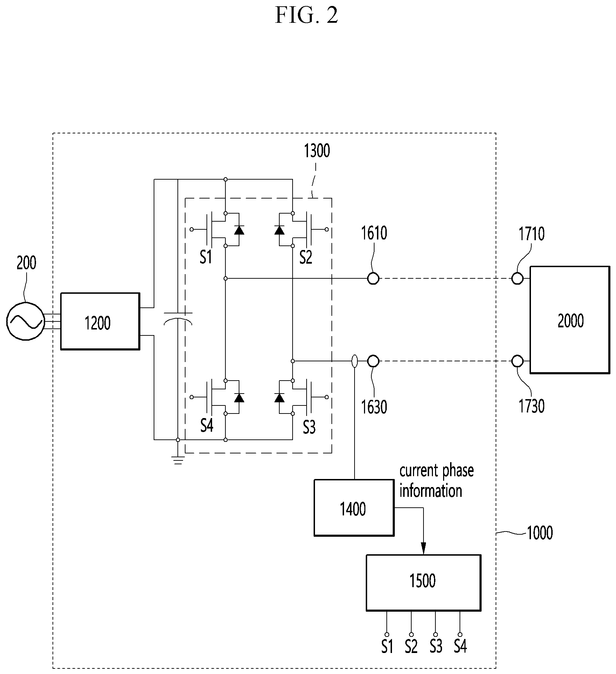

FIG. 2 is a diagram illustrating a radio frequency (RF) generator 1000 according to an embodiment.

Referring to FIG. 2, the RF generator 1000 may include 200, a rectifier 1200, an inverter 1300, a sensor module 1400, and a controller 1500. The RF generator 1000 may convert first AC power supplied from the AC power source 200 into second AC power and may supply the second AC power to a load. For example, the RF generator 1000 may convert the first AC power commonly used in homes or industries into the second AC power having a frequency ranging from several hundreds of kHz to several tens of MHz and power of several kW or more, and may provide the second AC power to a load.

Herein, the load may include the antenna structure 2000 and plasma generated by the antenna structure 2000. Herein, the load may have a resonant frequency that varies over time due to the induced plasma.

In the meantime, the RF generator 1000 and the load may be electrically and/or physically connected by one or more nodes. Referring to FIG. 2, two nodes 1610 and 1630 at the side of the RF generator 1000 and two nodes 1710 and 1730 at the side of the load are electrically and/or physically connected. For example, the node 1610 may be connected to the node 1710, and the node 1630 may be connected to the node 1730. For example, the node 1610 may be connected to the node 1710 via one conductive wire, and the node 1630 may be connected to the node 1730 via another one conductive wire.

In the meantime, the nodes 1610, 1630, 1710, and 1730 may be implemented in the form of terminals. In this case, the terminal of the node 1610 and the terminal of the node 1710 may be connected via an electric wire, a cable, or a connector, and the terminal of the node 1630 and the terminal of the node 1730 may be connected via an electric wire, a cable, or a connector.

Hereinafter, for convenience of description, it is assumed that the RF generator 1000 and the load are connected through the nodes 1610, 1630, 1710, and 1730. That is, for convenience of description, configurations of the nodes 1610, 1630, 1710, and 1730 may be omitted from the drawings or the detailed description of the specification. However, it will be readily inferred by those skilled in the art, from the above description, that the RF generator 1000 and the load are connected through the nodes 1610, 1630, 1710, and 1730.

The rectifier 1200 may convert output of the AC power source 200 into direct current. The rectifier 1200 may convert the first AC power supplied from the AC power source 200 into DC power and may apply the DC power to the both ends of the inverter 1300. In the meantime, in the present disclosure, the DC power may be interpreted as referring to DC current or DC voltage.

The inverter 1300 may receive DC power from the rectifier 1200 and may provide second AC power to the load. For example, the inverter 1300 may receive a switch signal from the controller 1500 and may use the received switch signal to provide the second AC power to the load.

The inverter 1300 may include at least one switch element controlled by a switch signal, and the second AC power supplied from the inverter 1300 to the load may have a driving frequency set on the basis of the switch signal provided to the inverter 1300 from the controller 1500.

For example, the inverter 1300 may be implemented in the form of a full bridge. Specifically, the inverter 1300 may include first to fourth switches S1, S2, S3, and S4. Herein, the first to fourth switches S1, S2, S3, and S4 may be turned on or off by receiving switch signals from the controller 1500. Herein, when the first and third switches S1 and S3 are turned on and the second and fourth switches S2 and S4 are turned off, a positive voltage may be applied to the load. When the first and third switches S1 and S3 are turned off and the second and fourth switches S2 and S4 are turned on, a negative voltage may be applied to the load. In this manner, the inverter 1300 may apply AC power having a particular frequency by alternately applying a positive voltage and a negative voltage to the load.

The implementation of the inverter 1300 is not limited to the above-described form, and may refer to a configuration including a circuit structure that performs a function of converting DC power into AC power.

The inverter 1300 may be controlled according to a frequency control method of the controller 1500, for example, time delay, pulse width modulation (PWM), or a combination thereof.

In the meantime, a capacitive element may be disposed between the rectifier 1200 and the inverter 1300. For example, the RF generator 1000 may include a capacitor connected in parallel with the rectifier 1200 and the inverter 1300, and the capacitor may discharge an AC component of power applied to the inverter 1300 to a ground node (GND).

The controller 1500 may generate a switch signal. Specifically, the controller 1500 may receive sensed data from the sensor module 1400, which will be described later, and generate the above-described switch signal. For example, the controller 1500 may be implemented to obtain data related to a resonant frequency, such as current and voltage of the load, from the sensor module 1400 and generate a switch signal. Specifically, the controller 1500 may obtain phase difference data or delay time by using phase data of current applied to the load and phase data of voltage applied to the load obtained from the sensor module 1400, and may generate a switch signal on the basis of the phase difference data or delay time.

The controller 1900 may be implemented as a device such as a central processing unit (CPU), a microprocessor, a processor core, a multiprocessor, an application-specific integrated circuit (ASIC), or a field programmable gate array (FPGA) according to hardware or software or a combination thereof.

The sensor module 1400 may provide the controller 1500 with data related to a resonant frequency of the load or data related to power supplied to the load.

As described above, the RF generator 1000 may control a driving frequency of the second AC power provided to the load, on the basis of the data related to the resonant frequency of the load. In other words, the RF generator 1000 may track the resonant frequency of the load that varies according to plasma generation and may output the driving frequency of the second AC power such that the driving frequency of the second AC power corresponds to the resonant frequency of the load. Accordingly, unnecessary power consumption may be prevented and durability of a plasma system may be improved.

In the meantime, although not shown in FIG. 2, the RF generator 1000 may include a memory. The memory may store various types of data. The memory may store various types of data temporarily or semi-permanently. Examples of the memory may include a hard disk drive (HDD), a solid-state drive (SSD), a flash memory, read-only memory (ROM), and random-access memory (RAM). The memory may be provided in a form embedded in the RF generator 1000 or a detachable form.

In addition, the RF generator 1000 may include an input part for receiving input from a user. The input part may receive user input from the user. The user input may be provided in various forms including key input, touch input, and voice input. Examples of the input part may include conventional forms such as a keypad, a keyboard, and a mouse as well as a touch sensor for detecting a user's touch and various other types of input means for detecting or receiving various types of user input. The input part is a comprehensive concept encompassing all such input means.

In addition, the RF generator 1000 may include an output part for providing information to a user. The output part may output information (e.g., a sensor value measured by the sensor module 1400, a driving frequency of the RF generator 1000, and a temperature of the antenna structure 2000) on a state of the plasma inducing system 100 and may provide the information to the user. The output part is a comprehensive concept encompassing a display for outputting images, a speaker for outputting sound, a haptic device for generating vibration, and various other types of output means.

The RF generator 1000 described above may omit at least one of its elements. For example, the RF generator 1000 may not include the sensor module 1400 and may obtain electrical data of the load from an external sensor. As another example, the RF generator 1000 may not include the AC power source 200 and the rectifier 1200 and may receive DC power or rectified DC power from outside.

### [Antenna structure]

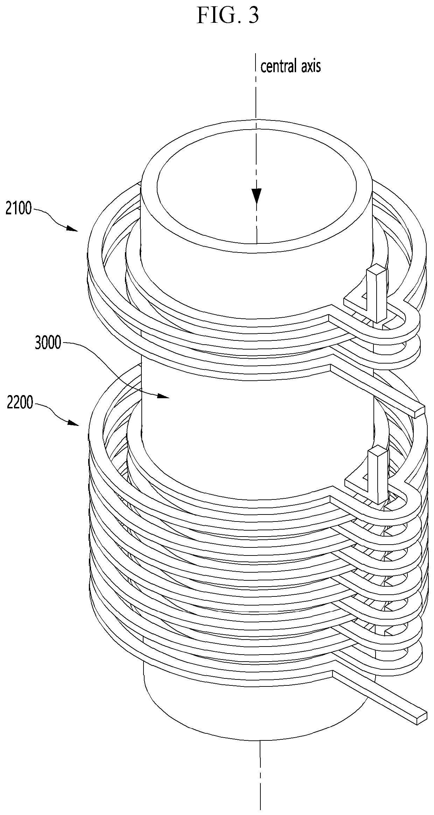

Hereinafter, an antenna structure 2200 will be described in detail with reference to FIGS. 3 to 5.

FIG. 3 is a diagram illustrating an antenna structure 2000 according to an embodiment.

Referring to FIG. 3, the antenna structure 2000 may include an ignition antenna structure 2100, and a maintaining antenna structure 2200. The ignition antenna structure 2100 may be understood as an antenna module for plasma ignition, and the maintaining antenna structure 2200 may be understood as an antenna module for maintaining the ignited plasma. A process in which plasma is ignited and maintained will be described later.

The ignition antenna structure 2100 may be disposed around the discharging tube 3000 with respect to the central axis of the discharging tube 3000. The ignition antenna structure 2100 may be implemented in a coil-like shape or a ring shape that surrounds an outer surface of the discharging tube 3000.

The ignition antenna structure 2100 may have a layered structure. The ignition antenna structure 2100 may have a structure in which identical or similar structures are stacked in the length direction of the discharging tube 3000. For example, as shown in FIG. 3, the ignition antenna structure 2100 may have a two-layer structure including two layer antennas. The number of layers of the ignition antenna structure 2100 is not limited to two, and may be appropriately determined as necessary.

One layer of the ignition antenna structure 2100 may comprise a plurality of turns (multi-turns). For example, as shown in FIG. 3, the ignition antenna structure 2100 may comprise two turn antennas, that is, an inner turn antenna surrounding an outer surface of the discharging tube 3000 and an outer turn antenna surrounding the inner turn antenna. The number of turns constituting each layer of the ignition antenna structure 2100 is not limited two, and may be appropriately determined as necessary.

The maintaining antenna structure 2200 may be disposed around the discharging tube 3000 with respect to the central axis of the discharging tube 3000. The maintaining antenna structure 2200 may be implemented in a coil-like shape or a ring shape that surrounds the outer surface of the discharging tube 3000.

The maintaining antenna structure 2200 may have a layered structure. The maintaining antenna structure 2200 may have a structure in which identical or similar structures are stacked in the length direction of the discharging tube 3000. For example, as shown in FIG. 3, the maintaining antenna structure 2200 may have a seven-layer structure. The number of layers of the maintaining antenna structure 2200 is not limited to seven, and may be appropriately determined as necessary.

One layer of the maintaining antenna structure 2200 may comprise a plurality of turns. For example, as shown in FIG. 3, the maintaining antenna structure 2200 may comprise two turn antennas, that is, an inner turn antenna surrounding the outer surface of the discharging tube 3000 and an outer turn antenna surrounding the inner turn antenna. The number of turns constituting each layer of the maintaining antenna structure 2200 is not limited to two, and may be appropriately determined as necessary.

The maintaining antenna structure 2200 may include at least one capacitive element. For example, a capacitive element may be electrically interposed between the plurality of antennas constituting the maintaining antenna structure 2200. Specifically, when the maintaining antenna structure 2200 includes a plurality of layer antennas and each layer antenna includes a plurality of turn antennas, a capacitive element may be electrically interposed between the plurality of layer antennas and/or the plurality of turn antennas.

Herein, the capacitive element may refer to an element, such as a condenser, a capacitor, a multilayer ceramic capacitor, or an ultracapacitor, having a function of storing electrical energy or an equivalent circuit thereof.

Unlike the maintaining antenna structure 2200, the ignition antenna structure 2100 may include a plurality of layer antennas and each layer antenna may include a plurality of turn antennas, but a capacitive element may not be included between the plurality of layer antennas and/or the plurality of turn antennas. This is because, when a capacitive element is included in an antenna module, the voltage applied to the both ends of the antenna module is relatively low, whereas, as will be described later, a relatively high voltage needs to be applied to the ignition antenna structure 2100 during a plasma induction process. It is noted that the ignition antenna structure 2100 may include a capacitive element and the maintaining antenna structure 2200 may not include a capacitive element.

The ignition antenna structure 2100 and the maintaining antenna structure 2200 may be disposed around the discharging tube 3000 while being spaced apart from each other by a preset distance. For example, as shown in FIG. 3, the maintaining antenna structure 2200 may be disposed spaced apart from the ignition antenna structure 2100 by a preset distance in the length direction of the discharging tube 3000.

In the meantime, energy conversion efficiency (ECE) may vary depending on the shape of the maintaining antenna structure 2200. Herein, the energy conversion efficiency may refer to a degree to which gases supplied to the discharging tube 3000 are converted into a synthesis gas by plasma reforming.

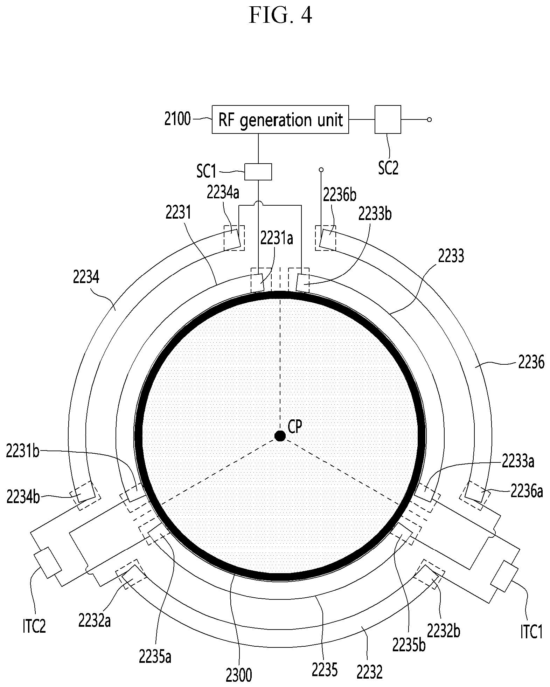

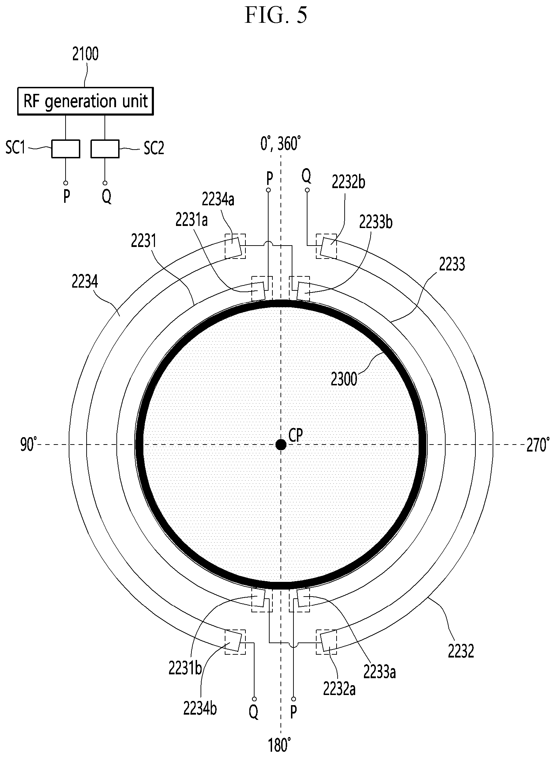

Hereinafter, the shape of the maintaining antenna structure 2200 for increasing the energy conversion efficiency will be described with reference to FIGS. 4 and 5.

FIG. 4 is a diagram illustrating a maintaining antenna structure 2200 according to a first embodiment.

Referring to FIG. 4, the maintaining antenna structure 2200 may comprise a plurality of antenna segments. For example, the maintaining antenna structure 2200 may include first to third inner antenna segments 2231, 2233, and 2235 constituting an inner turn, and first to third outer antenna segments 2232, 2234, and 2236.

The first inner antenna segment 2231 may be electrically connected to the first outer antenna segment 2232. other end 2231b of the first inner antenna segment may be electrically connected to one end 2232a of the first outer antenna segment. The other end 2231b of the first inner antenna segment may be connected to the one end 2232a of the first outer antenna segment through a first connection part. Herein, the first connection part may be implemented as a U-shaped conductive wire or coil, but is not limited thereto.

In the meantime, one end 2231a of the first inner antenna segment may be electrically connected to one end of the RF generation part 2100. Herein, a first auxiliary capacitive element SC1 may be electrically interposed between one end 2231a of the first inner antenna segment and the RF generation part 2100.

The first outer antenna segment 2232 may be electrically connected to the second inner antenna segment 2233. other end 2232b of the first outer antenna segment may be electrically connected to one end 2233a of the second inner antenna segment. The other end 2232b of the first outer antenna segment may be connected to the one end 2233a of the second inner antenna segment through a first inter-turn capacitive element ITC1.

The second inner antenna segment 2233 may be electrically connected to the second outer antenna segment 2234. other end 2233b of the second inner antenna segment may be electrically connected to one end 2234a of the second outer antenna segment. The other end 2233b of the second inner antenna segment may be connected to the one end 2234a of the second outer antenna segment through a second connection part. Herein, the second connection part may be implemented as a U-shaped conductive wire or coil, but is not limited thereto.

The second outer antenna segment 2234 may be electrically connected to the third inner antenna segment 2235. other end 2234b of the second outer antenna segment may be electrically connected to one end 2235a of the third inner antenna segment. The other end 2234b of the second outer antenna segment may be connected to the one end 2235a of the third inner antenna segment through a second inter-turn capacitive element ITC2 (a second inner layer capacitive element).

The third inner antenna segment 2235 may be electrically connected to the third outer antenna segment 2236. other end 2235b of the third inner antenna segment may be electrically connected to one end 2236a of the third outer antenna segment. The other end 2235b of the third inner antenna segment may be connected to the one end 2236a of the third outer antenna segment through a third connection part. Herein, the third connection part may be implemented as a U-shaped conductive wire or coil, but is not limited thereto.

In the meantime, other end 2236b of the third outer antenna segment may be electrically connected to an antenna segment of another layer. However, when the maintaining antenna structure 2200 comprise one layer, the other end 2236b of the third outer antenna segment may be electrically connected to other end of the RF generation part 2100. Herein, a second auxiliary capacitive element SC2 may be electrically interposed between the other end 2236b of the third outer antenna segment and the RF generation part 2100. However, either the first auxiliary capacitive element SC1 or the second auxiliary capacitive element SC2 may be omitted.

When the antenna segments within the maintaining antenna structure 2200 are connected as described above, the first inner antenna segment 2231, the first outer antenna segment 2232, the first inter-turn capacitive element ITC1, the second inner antenna segment 2233, the second outer antenna segment 2234, the second inter-turn capacitive element ITC2, the third inner antenna segment 2235, and the third outer antenna segment 2236 may be connected in series in that order with respect to the RF generation part 2100.

Herein, the first outer antenna segment 2232 and the first inter-turn capacitive element ITC1 are electrically interposed between the first inner antenna segment 2231 and the second inner antenna segment 2233.

In addition, the second outer antenna segment 2234 and the second inter-turn capacitive element ITC2 may be electrically interposed between the second inner antenna segment 2233 and the third inner antenna segment 2235.

In addition, the second inter-turn capacitive element ITC2 and the third inner antenna segment 2235 may be electrically interposed between the second outer antenna segment 2234 and the third outer antenna segment 2236.

FIG. 4 shows one layer antenna, and the maintaining antenna structure 2200 may comprise a plurality of layer antennas, and each layer antenna may be implemented as shown in FIG. 4. Herein, a third outer antenna segment of a first layer antenna may be electrically connected to a first inner antenna segment of a second layer antenna that is a next layer of the first layer antenna, and an inter-layer capacitor may be electrically connected therebetween.

FIG. 5 is a diagram illustrating a maintaining antenna structure 2200 according to a second embodiment.

Referring to FIG. 5, the maintaining antenna structure 2200 may comprise a plurality of antenna segments. For example, the maintaining antenna structure 2200 may include a first inner antenna segment 2231 and a second inner antenna segment 2233 constituting an inner turn, and a first outer antenna segment 2232 and a second outer antenna segment 2234 constituting an outer turn.

The first inner antenna segment 2231 may be electrically connected to the first outer antenna segment 2232, and the second inner antenna segment 2233 may be electrically connected to the second outer antenna segment 2234. An aspect in which the first inner antenna segment 2231 is connected to the first outer antenna segment 2232 and an aspect in which the second inner antenna segment 2233 is connected to the second outer antenna segment 2234 are the same as those described with reference to FIG. 4, so a detailed description thereof will be omitted.

In the meantime, other end 2232b of the first outer antenna segment 2232 may be connected to a first inner antenna segment of another layer antenna, or when the maintaining antenna structure 2200 comprises one layer, the other end 2232b of the first outer antenna segment 2232 may be connected to an RF generation part 2100. In addition, other end 2234b of the second outer antenna segment 2234 may also be connected to a second inner antenna segment of another layer antenna, or when the maintaining antenna structure 2200 comprises one layer, the other end 2234b of the second outer antenna segment 2234 may be connected to the RF generation part 2100. Herein, an inter-layer capacitor may be electrically interposed between antenna segments of different layer antennas.

In other words, in the case of the maintaining antenna structure 2200 according to the second embodiment, a first inner antenna segment and a first outer antenna segment of each layer may be connected to each other in series to form one closed circuit with the RF generation part 2100, and a second inner antenna segment and a second outer antenna segment of each layer may be connected to each other in series to form another one closed circuit with the RF generation part 2100.

### [Plasma induction process]

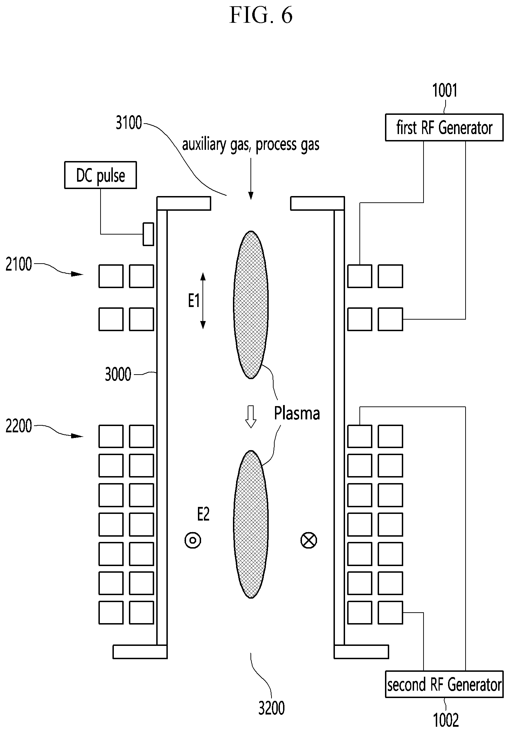

Hereinafter, a process in which plasma is induced in a plasma inducing apparatus 100 will be described with reference to FIG. 6.

FIG. 6 is a diagram illustrating a process in which plasma is induced according to an embodiment of the present disclosure.

Referring to FIG. 6, a plasma inducing system 100 may include a discharging tube 3000 for providing a space in which plasma is induced, an ignition antenna structure 2100 and a maintaining antenna structure 2200 which are disposed around the discharging tube 3000, , a first RF generator 1001 for applying power to the ignition antenna structure 2100, and a second RF generator 1002 for applying power to the maintaining antenna structure 2200. In the meantime, the discharging tube 3000 may include an inlet 3100 for introducing an auxiliary gas, and an outlet 3200 through which the auxiliary gas is processed and discharged from the discharging tube 3000. In the meantime, the auxiliary gas is a gas used to generate plasma, and may be referred to as a process gas.

A process of inducing plasma may be broadly divided into a plasma igniting process and a plasma maintaining process.

In the plasma igniting process, the auxiliary gas flows into the discharging tube 3000 through the inlet 3100 of the discharging tube 3000, and when voltage is applied to the ignition antenna structure 2100 by the first RF generator 1001 and an electric field E1 is formed, the introduced auxiliary gas is accelerated by the electric field E1 and is subjected to phase transition into plasma. In the plasma igniting process, as electron density increases, plasma transition takes place from an E mode in which capacitive coupling is dominant to an H mode in which inductive coupling is dominant.

In the meantime, it is noted in advance that the ignition antenna structure 2100 is an expression used to distinguish it from the maintaining antenna structure 2200 for convenience of description. The ignition antenna structure 2100 may also be referred to as a first antenna structure that refers to any antenna structure.

Before the igniting process, a process of increasing charge density inside the discharging tube 3000 may be performed in advance. Specifically, high voltage may be applied inside the discharging tube 3000 by applying a DC pulse voltage to an electrode attached to the discharging tube 3000. When the high voltage is applied inside the discharging tube 3000, electrons may be emitted from the electrode into the inside of the discharging tube 300. In addition, the gas inside the discharging tube 3000 may be ionized by the high voltage applied from the electrode. Accordingly, charge density inside the discharging tube 3000 may be increased.

In the plasma maintaining process, AC current flows through the maintaining antenna structure 2200 by the second RF generator 1002 to generate a continuously varying magnetic field, and when an induced electric field E2 is formed according to a change in the magnetic field, particles in the H-mode plasma state continuously move by the induced electric field E2, thereby allowing plasma to be stably maintained.

In the meantime, the maintaining antenna structure 2200 is an expression for distinguishing it from the ignition antenna structure 2100 for convenience of description. The maintaining antenna structure 2200 may also be referred to as a second antenna structure that refers to any antenna structure.

In other words, the process of inducing plasma may be understood such that the auxiliary gas is brought into the E-mode plasma state by using the ignition antenna structure 2100 and the first RF generator 1001 and then transitions to the H-mode plasma state and the H-mode plasma state is maintained by using the maintaining antenna structure 2200 and the second RF generator 1002.

Herein, the ignition antenna structure 2100 and the maintaining antenna structure 2200 each generate a magnetic field as voltage or current is applied. Generation of the magnetic fields may cause problems such as damage to or malfunction of the RF generator 1000, in addition to plasma induction, as will be described later.

### [Problems in the related art]

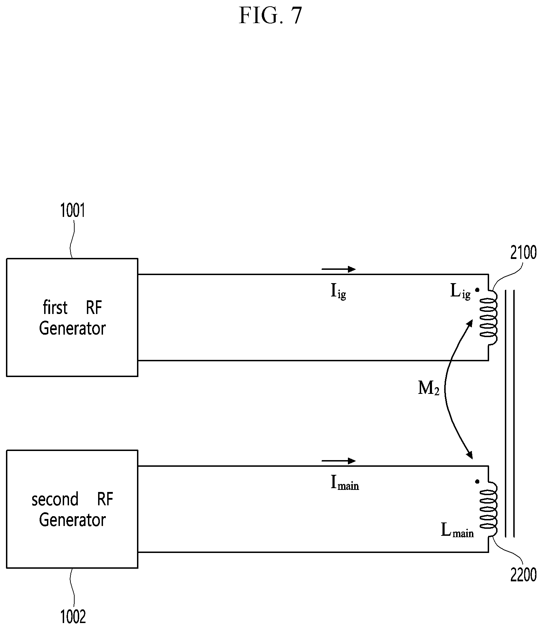

FIGS. 7 to 8 are diagrams illustrating a process in which an induced electromotive force is generated in a maintaining antenna structure 2200 by an ignition antenna structure 2100 according to an embodiment of the present disclosure. FIG. 7 is a diagram showing application of power to an antenna structure 2000 in a plasma inducing apparatus 100, and it is noted in advance that the shape or structure of the antenna structure 2000 is schematically illustrated.

Referring to FIG. 7, an equivalent circuit in which a first RF generator 1001, a second RF generator 1002, the ignition antenna structure 2100, and the maintaining antenna structure 2200 are connected is shown. A first current (I_{ig}) may flow through the ignition antenna structure(2100) by the first RF generator 1001, and/or a second current (Iₘₐᵢₙ) may flow through the maintaining antenna structure 2200 by the second RF generator 1002. Herein, the ignition antenna structure 2100 and the maintaining antenna structure 2200 are disposed physically spaced apart from each other around the same discharging tube 3000, so mutual inductance (M₂) is generated between the ignition antenna structure 2100 and the maintaining antenna structure 2200. For example, the mutual inductance (M₂) may be generated as shown in [Equation 1] below on the basis of inductance (L_{ig}) of the ignition antenna structure 2100, inductance (Lₘₐᵢₙ) of the maintaining antenna structure 2200, and a coupling coefficient (k₂) generated between the inductance (L_{ig}) and the inductance (Lₘₐᵢₙ).${M}_{2} = {k}_{2} \sqrt{{L}_{ig} {L}_{main}}$

Accordingly, an induced current caused by an induced electromotive force may flow through the maintaining antenna structure 2200 and the second RF generator 1002 by the AC power supplied by the first RF generator 1001, and an induced current caused by an induced electromotive force may flow through the ignition antenna structure 2100 and the first RF generator 1001 by the AC power supplied by the second RF generator 1002.

However, the induced current generated as described above may cause various problems in the following cases.

In the meantime, in the following description of the present specification, a clockwise direction refers to a direction in which rotation continuously proceeds to the right when viewed from the center (or the central axis) in one direction. In addition, a counterclockwise direction refers to a direction in which rotation continuously proceeds to the left when viewed from the center (or the central axis) in one direction.

### Case 1) The first RF generator 1001 supplies power to the ignition antenna structure 2100 and the second RF generator 1002 does not supply power to the maintaining antenna structure 2200

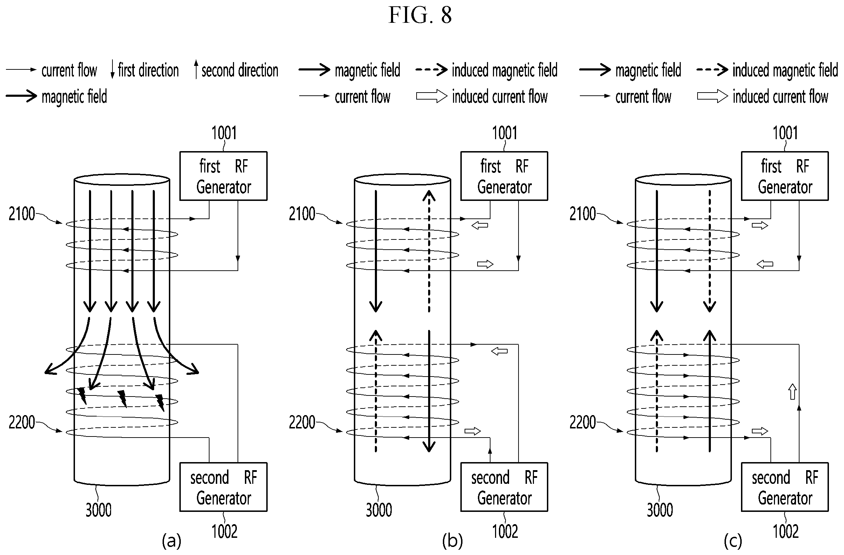

FIG. 8(a) is a diagram illustrating a problem of Case 1 described above. In the plasma igniting process described above with reference to FIG. 6, when AC power is applied to the ignition antenna structure 2100 by the first RF generator 1001, a magnetic field may be formed by current flowing through the ignition antenna structure 2100. For example, as shown in FIG. 8(a), when current flows through the ignition antenna structure 2100 in the clockwise direction, a magnetic field may be formed around a first direction among directions parallel to the central axis of the discharging tube 3000 (Ampere's circuital law). As another example, when current flows through the ignition antenna structure 2100 in the counterclockwise direction, a magnetic field may be formed around a second direction opposite to the first direction.

Herein, the first direction is a direction from an upper surface of the discharging tube 3000 toward a lower surface thereof, and may refer to a direction in which the auxiliary gas or the process gas flows, a direction in which the maintaining antenna structure 2200 is spaced apart from the ignition antenna structure 2100, or a direction in which plasma ignited within the discharging tube 3000 moves. The second direction is a direction from the lower surface of the discharging tube 3000 toward the upper surface thereof, and may refer to the direction opposite to the first direction.

The direction of the magnetic field formed by the ignition antenna structure 2100 varies according to the direction of AC current flowing through the ignition antenna structure 2100. That is, a change in the direction of current flowing through the ignition antenna structure 2100 may cause a change in the magnetic field in a region in which the maintaining antenna structure 2200 is positioned. Accordingly, an induced electromotive force is generated in the maintaining antenna structure 2200.

When the induced electromotive force is generated in the maintaining antenna structure 2200, current flows through the maintaining antenna structure 2200 accordingly, thereby causing a change in an electromagnetic field inside the discharging tube 3000 corresponding to a position of the maintaining antenna structure 2200. That is, an effect that energy supplied by the first RF generator 1001 may be distributed to the ignition antenna structure 2100 and the maintaining antenna structure 2200 is caused.

In this case, although energy needs to be intensively supplied to the ignition antenna structure 2100 in order to efficiently ignite plasma in the igniting process, the energy is not intensively supplied to the ignition antenna structure 2100, thereby failing to efficiently perform the plasma igniting process.

In addition, the induced electromotive force generated in the maintaining antenna structure 2200 may affect the second RF generator 1002 electrically connected to the maintaining antenna structure 2200. For example, voltage stress may be generated in the second RF generator 1002 by the induced electromotive force generated in the maintaining antenna structure 2200. Such voltage stress may cause damage to the second RF generator 1002 or may cause the second RF generator 1002 to operate in an unintended direction during the plasma induction process.

The above-described problem is particularly pronounced in that the ignition antenna structure 2100 performs plasma ignition. For plasma ignition, a strong electric field is required, and in order to form the strong electric field, a relatively high voltage needs to be applied to the ignition antenna structure 2100. Accordingly, the strength of the magnetic field generated by the ignition antenna structure 2100 is also increased, and thus the magnitude of the induced electromotive force generated in the maintaining antenna structure 2200, that is, a burden on the second RF generator 1002, is also increased.

### Case 2) The second RF generator 1001 supplies power to the maintaining antenna structure 2100 and the first RF generator 1002 does not supply power to the ignition antenna structure 2200

In addition, as described above, while plasma ignited by the ignition antenna structure 2100 moves in the direction of the maintaining antenna structure 2200, the second RF generator 1002 operates and the operation of the first RF generator 1001 is stopped. In this case, a problem contrasting with that of (Case 1) may occur.

For example, unlike FIG. 8(a), when AC power is applied to the maintaining antenna structure 2200 by the second RF generator 1002, a magnetic field is formed by current flowing through the maintaining antenna structure 2200. Such a magnetic field causes a change in a magnetic field in a region in which the ignition antenna structure 2100 is positioned, and accordingly, an induced electromotive force is generated and an induced current flows in the ignition antenna structure 2200.

In this case, even though the plasma inducing apparatus 100 does not intend to perform an igniting process for generating plasma, unnecessary movement of plasma may occur, for example, plasma that is to be maintained inside the discharging tube 3000 corresponding to the maintaining antenna structure 2200 moves to a position corresponding to the ignition antenna structure 2100 due to the induced electromotive force and the induced current of the ignition antenna structure 2100.

In order to maintain plasma efficiently and stably, it is preferable that after the igniting process, plasma exists inside the discharging tube 3000 corresponding to the maintaining antenna structure 2200, and does not move back into the discharging tube 300 corresponding to the ignition antenna structure 2100. In particular, as described above with reference to FIGS. 3 to 5, the ignition antenna structure 2100 does not include a capacitive element, that is, a capacitor, therein, but the maintaining antenna structure 2200 includes a plurality of capacitors therein.

Therefore, since voltage stability and the maximum voltage of the ignition antenna structure 2100 are different from those of the maintaining antenna structure 2200, it is not preferable that discharged plasma moves back into or remains inside the discharging tube 300 corresponding to the ignition antenna structure 2100 in terms of stable maintenance of plasma discharge and discharge efficiency.

In addition, similarly to the above description, the induced electromotive force generated in the ignition antenna structure 2100 may generate voltage stress in the first RF generator 1001 electrically connected to the ignition antenna structure 2100, and may cause the first RF generator 1001 to be damaged or to operate in an unintended direction in the plasma induction process.

### Case 3) The first RF generator 1001 and the second RF generator 1002 simultaneously supply power to the ignition antenna structure 2100 and the maintaining antenna structure 2200, respectively

In the process in which plasma ignited by the ignition antenna structure 2100 moves in the direction of the maintaining antenna structure 2200, there may be a period (approximately 1 to 5 seconds) during which the first RF generator 1001 and the second RF generator 1002 operate simultaneously, from a time point when the second RF generator 1002 starts operation until the operation of the first RF generator 1001 is stopped.

In other words, there may be a period in which the first RF generator 1001 and the second RF generator 1002 supply power simultaneously. For example, the first RF generator 1001 supplies power to the ignition antenna structure 2100 and monitors plasma generated by the ignition antenna structure 2100. When it is determined that plasma needs to be moved to the maintaining antenna structure 2200, the second RF generator 1002 is operated to supply power to the maintaining antenna structure 2200.

Then, due to the induced electromotive force generated in the maintaining antenna structure 2200 by the second RF generator 1002, plasma moves from the ignition antenna structure 2100 in the direction of the maintaining antenna structure 2200. In the meantime, when it is determined that plasma has sufficiently moved toward the maintaining antenna structure 2200 and is maintained, the first RF generator 1001 may stop supply of power provided to the ignition antenna structure 2100. From that time, the operation of the first RF generator 1001 may be stopped and only the second RF generator 1002 may operate.

That is, according to the above-described operation, from the time point at which the second RF generator 1002 starts operating until the operation of the first RF generator 1001 is stopped, the first RF generator 1001 and the second RF generator 1002 may simultaneously supply power to the ignition antenna structure 2100 and the maintaining antenna structure 2200, respectively.

In this period, while the induced electromotive force is generated in the maintaining antenna structure 2200 by the first RF generator 1001, the second RF generator 1002 supplies power, thereby resulting in a risk of abnormal operation or damage to the second RF generator 1002.

For example, as shown in FIG. 8(b), when winding directions of the ignition antenna structure 2100 and the maintaining antenna structure 2200 are the same and directions of currents respectively applied by the first RF generator 1001 and the second RF generator 1002 are the same, the current applied by the first RF generator 1001 may be canceled by the induced electromotive force of the ignition antenna structure 2100 and the current applied by the second RF generator 1001 may be canceled by the induced electromotive force of the maintaining antenna structure 2200. Herein, the fact that directions of currents are the same means that the currents flow in the same direction within the antenna structures. Referring to FIG. 8(b), since current flows in a direction (that is, the second direction) from a lower end to an upper end of the ignition antenna structure 2100 and current flows in a direction (that is, the second direction) from a lower end to an upper end of the maintaining antenna structure 2200, the directions of the currents are the same.

If currents are canceled, an electromagnetic field generated inside the discharging tube 3000 is reduced more than expected, potentially affecting movement and maintenance of plasma. For example, when higher voltage is applied to the ignition antenna structure 2100 than to the maintaining antenna structure 2200, the induced electromotive force of the maintaining antenna structure 2200 is strongly generated and strongly cancels the current flowing through the maintaining antenna structure 2200. Therefore, stable movement of plasma from a position inside the discharging tube 3000 corresponding to the ignition antenna structure 2100 to a position inside discharging tube 3000 corresponding to the maintaining antenna structure 2200 may not be performed.

In the meantime, when winding directions of the ignition antenna structure 2100 and the maintaining antenna structure 2200 are opposite to each other and the directions of the currents respectively applied by the first RF generator 1001 and the second RF generator 1002 are opposite to each other, the induced electromotive forces may cancel the currents respectively flowing through the ignition antenna structure 2100 and the maintaining antenna structure 2200. Accordingly, a problem by this may be the same as or similar to those described above.

In addition, as shown in FIG. 8(c), when winding directions of the ignition antenna structure 2100 and the maintaining antenna structure 2200 are the same and directions of currents respectively applied by the first RF generator 1001 and the second RF generator 1002 are opposite to each other, the current applied by the first RF generator 1001 may be amplified by the induced electromotive force of the ignition antenna structure 2100 and the current applied by the second RF generator 1002 may be amplified by the induced electromotive force of the maintaining antenna structure 2200. In this case, as described above, movement and maintenance processes of plasma may not be efficiently performed. In addition, due to the amplified currents, voltage stress is generated in both the first RF generator 1001 and the second RF generator 1002, which may cause the RF generators 1001 and 1002 to be damaged or to operate in unintended directions in the plasma induction process. Herein, referring to FIG. 8(c), current flows in a direction (that is, the second direction) from the lower end to the upper end of the ignition antenna structure 2100, but current flows in a direction (that is, the first direction) from the upper end to the lower end of the maintaining antenna structure 2200, so the directions of the currents are opposite to each other.

In the meantime, when winding directions of the ignition antenna structure 2100 and the maintaining antenna structure 2200 are opposite to each other and the directions of the currents respectively applied by the first RF generator 1001 and the second RF generator 1002 are the same, the induced electromotive forces may amplify the currents respectively flowing through the ignition antenna structure 2100 and the maintaining antenna structure 2200. Accordingly, a problem by this may be the same as or similar to those described above.

### [Configuration of a plasma inducing apparatus according to an embodiment of the present disclosure]

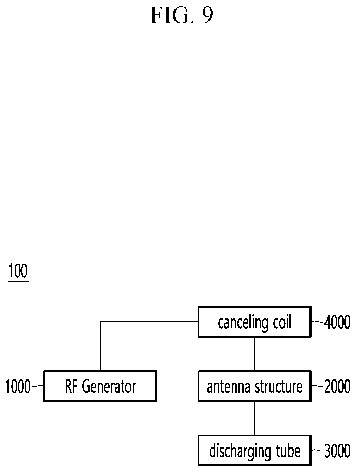

Hereinafter, a method for solving the above-described problems will be described with reference to FIGS. 9 to 12.

The plasma inducing apparatus 100 may include a means or a structure for canceling the induced current generated by the ignition antenna structure 2100 and/or the maintaining antenna structure 2200, and the means or the structure may be defined as a canceling coil 4000.

For example, the induced current may be generated in the maintaining antenna structure 2200 and/or the ignition antenna structure 2100 by power supplied by the first RF generator 1001 and/or the second RF generator 1002, and such induced current may cause the problems described with reference to FIGS. 7 to 8. Accordingly, the means or the structure for canceling such induced current may be defined as the canceling coil 4000.

In the meantime, the canceling coil 4000 may be implemented in a ring shape as shown in FIG. 3 or in a coil-like shape as shown in FIG. 4 or 5. In addition, similarly to the ignition antenna structure 2100 and/or the maintaining antenna structure 2200 described above, the canceling coil 4000 may comprise a plurality of layers and/or a plurality of turns. In addition, the canceling coil 4000 may be implemented in the same or a similar form as the antenna structure 2000, so it may also be referred to as a canceling antenna.

The canceling coil 4000 may cancel the induced current generated by a first induced electromotive force by generating a second induced electromotive force having a direction opposite to that of the first induced electromotive force generated in the antenna structure 2000. For example, when the canceling coil 4000 generates the second induced electromotive force having the direction opposite to that of the first induced electromotive force, the induced current having an opposite direction to that of the induced current generated by the first induced electromotive force is generated by the second induced electromotive force, and thus an effect that the induced currents flowing in opposite directions may cancel each other may be achieved.

In order to achieve the effect described above, referring to FIG. 9, the canceling coil 4000 may be electrically connected in series with the RF generator 1000 and the antenna structure 2000. For example, the canceling coil 4000 may be electrically interposed between the RF generator 1000 and the antenna structure 2000.

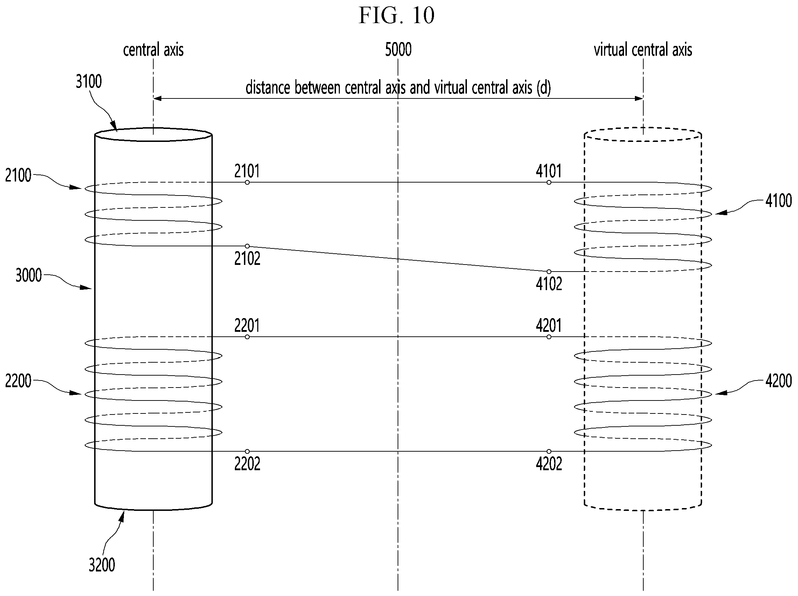

Regarding the canceling coil 4000 with reference to FIG. 10, the canceling coil 4000 may be physically positioned substantially spaced apart from the antenna structure 2000. In addition, the canceling coil 4000 may include a first canceling coil 4100 electrically connected to the ignition antenna structure 2100, and a second canceling coil 4200 electrically connected to the maintaining antenna structure 2200.

The first canceling coil 4100 and the second canceling coil 4200 may be disposed or wound around a (virtual) structure with respect to a (virtual) central axis. That is, the first canceling coil 4100 and the second canceling coil 4200 may be disposed according to a predetermined radius or a predetermined distance with respect to the same central axis. Herein, the first canceling coil 4100 and the second canceling coil 4200 may be actually disposed or wound around a physical structure (for example, an insulator) having a predetermined radius or a predetermined distance. Alternatively, assuming a virtual central axis and a predetermined radius (or a predetermined distance), the first canceling coil 4100 and the second canceling coil 4200 may be disposed or wound around the virtual central axis and the predetermined radius (or the predetermined distance).

However, the first canceling coil 4100 and the second canceling coil 4200 are not necessarily disposed with respect to the same central axis according to the above-described embodiment, and may be disposed according to a predetermined radius or a predetermined distance with respect to different central axes. That is, the first canceling coil 4100 and the second canceling coil 4200 only need to have mutual inductance capable of canceling an induced voltage generated between the ignition antenna structure 2100 and the maintaining antenna structure 2200, an arrangement structure between the first canceling coil 4100 and the second canceling coil 4200 is not limited and may be designed as long as such mutual inductance can be obtained.

However, for convenience of description, an embodiment of the present disclosure will be described assuming that the first canceling coil 4100 and the second canceling coil 4200 are disposed with respect to the same central axis.

In the meantime, the first canceling coil 4100 and the second canceling coil 4200 are disposed physically spaced apart from each other. As will be described later, the distance by which the first canceling coil 4100 and the second canceling coil 4200 are spaced apart may be shorter than the distance by which the antenna structure 2000 and the canceling coil 4000 are spaced apart. Herein, the distance by which the antenna structure 2000 and the canceling coil 4000 are spaced apart may be a distance (d) between the central axis of the discharging tube 3000 and a (virtual) central axis serving as a reference for winding the first canceling coil 4100 and the second canceling coil 4200.

Specifically, d needs to be a sufficiently long distance such that a coupling coefficient between the ignition antenna structure 2100 and the first canceling coil 4100 is zero, or is equal to or lower than a first threshold value. Simultaneously, d needs to be a sufficiently long distance such that a coupling coefficient between the maintaining antenna structure 2200 and the second canceling coil 4200 is zero, or is equal to or lower than the first threshold value. Simultaneously, d needs to be a sufficiently long distance such that a coupling coefficient between the ignition antenna structure 2200 and the second canceling coil 4200 is zero, or is equal to or lower than the first threshold value. Simultaneously, d needs to be a sufficiently long distance such that a coupling coefficient between the maintaining antenna structure 2200 and the first canceling coil 4200 is zero, or is equal to or lower than the first threshold value. Herein, the first threshold value may be a low value such that it is considered that no abnormality occurs in plasma ignition and maintenance and in the operation of the RF generator 1000 or no influence is exerted thereon due to mutual inductance between the canceling coil 4000 and the antenna structure 2000.

In an embodiment according to the present disclosure, in order to sufficiently obtain a desired canceling effect, only a first mutual inductance between the ignition antenna structure 2100 and the maintaining antenna structure 2200 and a second mutual inductance between the first canceling coil 4100 and the second canceling coil 4200 need to be generated, and any other mutual inductance between the canceling coil 4000 and the antenna structure 2000 need to be minimized as much as possible. This is because, if an induced electromotive force is generated due to mutual inductance between the canceling coil 4000 and the antenna structure 2000, the canceling effect of the present disclosure described later may not be sufficiently obtained, and problems identical or similar to those described above may occur due to the induced electromotive force.

In the meantime, when an installation site of the plasma inducing apparatus 100 according to the present disclosure is not sufficient to secure the distance d, a shielding device 5000 may be installed between the antenna structure 2000 and the canceling coil 4000 to prevent an induced electromotive force from being generated therebetween. For example, the shielding device 5000 may be a conductive plate (for example, an aluminum plate). The conductive plate may prevent the magnetic field generated by the RF generator from affecting the canceling coil 4000 due to eddy current generated in the conductive plate.

In the meantime, referring to FIG. 10, the both ends of the ignition antenna structure 2100 are electrically connected in series with the both ends of the first canceling coil 4100, and the both ends of the maintaining antenna structure 2200 are electrically connected in series with the both ends of the second canceling coil 4200.

For convenience of description, the both ends of the ignition antenna structure 2100 are referred to as a first end 2101 and a second end 2102. The first end 2101 is positioned closer to the inlet 3100 of the discharging tube 3000 than the second end 2102. In addition, the both ends of the maintaining antenna structure 2200 are referred to as a third end 2201 and a fourth end 2202. The third end 2201 is positioned closer to the second end 2102 than the fourth end 2202. The fourth end 2202 is positioned closer to the outlet 3200 of the discharging tube 3000 than the third end 2201.

In addition, the both ends of the first canceling coil 4100 are referred to as a fifth end 4101 and a sixth end 4102. Each of the fifth end 4101 and the sixth end 4102 may be electrically connected in series with a respective one of the first end 2101 and the second end 2102. FIG. 10 shows that the first end 2101 is connected to the fifth end 4101 and the second end 2102 is connected to the sixth end 4102. However, this is merely an example, and the first end 2101 may be connected to the sixth end 4102 and the second end 2102 may be connected to the fifth end 4101.

The both ends of the second canceling coil 4200 are referred to as a seventh end 4201 and an eighth end 4202. Each of the seventh end 4201 and the eighth end 4202 may be electrically connected in series with a respective one of the third end 2201 and the fourth end 2202. FIG. 10 shows that the third end 2201 is connected to the seventh end 4201 and the fourth end 2202 is connected to the eighth end 4202. However, this is merely an example, the third end 2201 may be connected to the eighth end 4202 and the fourth end 2202 may be connected to the seventh end 4201.

In other words, there may be various embodiments of connection forms between the canceling coil 4000 and the antenna structure 2000. These may be associated with winding directions of the first canceling coil 4100, the second canceling coil 4200, the ignition antenna structure 2100, and the maintaining antenna structure 2200. FIG. 10 shows that when the ignition antenna structure 2100 and the maintaining antenna structure 2200 are both wound in the counterclockwise direction and the first canceling coil 4100 and the second canceling coil 4200 are wound in opposite directions, namely, the counterclockwise direction and the clockwise direction, respectively, the first end 2101 is connected to the fifth end 4101, the second end 2102 is connected to the sixth end 4102, the third end 2201 is connected to the seventh end 4201, and the fourth end 2202 is connected to the eighth end 4202.

However, in addition to FIG. 10, there may be various embodiments capable of canceling an induced electromotive force by using the canceling coil 4000 according to the winding directions and the connection relationships of the both ends, which is intended in the present disclosure. This will be described later in detail.

In the meantime, for convenience of description, FIG. 10 does not show the RF generator 1000. However, based on the foregoing descriptions, it is apparent to those skilled in the art that the RF generator (1000) is interposed between the canceling coil 4000 and the antenna structure 2000. For example, the first RF generator 1001 may be interposed between the first end 2101 and the fifth end 4101, or may be interposed between the second end 2102 and the sixth end 4102. In addition, the second RF generator 1002 may be interposed between the third end 2201 and the seventh end 4201, or may be interposed between the fourth end 2202 and the eighth end 4202. In the meantime, the first RF generator 1001 and the second RF generator 1002 may be implemented by separate devices, respectively, or may be implemented by one device. For example, one RF generator 1000 may be implemented to apply voltage to each of the ignition antenna structure 2100 and the maintaining antenna structure 2200, and one RF generator 1000 may be functionally divided into the first RF generator 1001 and the second RF generator 1002.

In the meantime, for convenience of description, in FIG. 10, the ignition antenna structure 2100, the maintaining antenna structure 2200, the first canceling coil 4100, and the second canceling coil 4200 are described as coils each having a single turn, but are not limited thereto.

For example, each of the ignition antenna structure 2100, the maintaining antenna structure 2200, the first canceling coil 4100, and the second canceling coil 4200 may be a coil comprising a plurality of layers and a plurality of turns as described above with reference to FIG. 3. In addition, each of the ignition antenna structure 2100, the maintaining antenna structure 2200, the first canceling coil 4100, and the second canceling coil 4200 may be configured as the antenna structure described above with reference to FIG. 4 or 5 which comprises one or more layers.

### [A method of canceling an induced electromotive force according to an embodiment of the present disclosure]

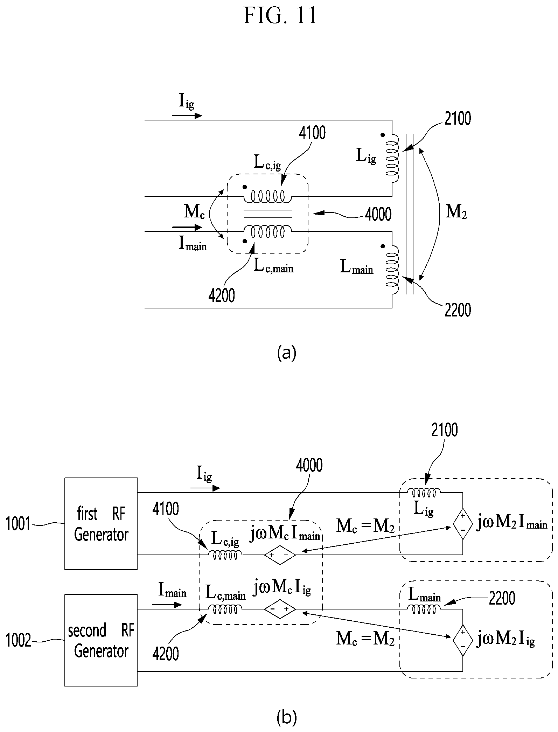

FIGS. 11 to 12 show a method of canceling an induced electromotive force according to an embodiment of the present disclosure and the canceling coil 4000 described with reference to FIGS. 9 to 10.

Referring to FIG. 11(a), the first canceling coil 4100 (L_{c,ig}) and the second canceling coil 4200 (L_{c,main}) having mutual inductance M_{c} may be electrically connected in series with the ignition antenna structure 2100 (L_{ig}) and the maintaining antenna structure 2200 (Lₘₐᵢₙ) having mutual inductance M₂, respectively. In other words, the first canceling coil 4100 (L_{c,ig}) may be electrically interposed between the first RF generator 1001 and the ignition antenna structure 2100 (L_{ig}), and the second canceling coil 4200 (L_{c,main}) may be electrically interposed between the second RF generator 1002 and the maintaining antenna structure 2200 (Lₘₐᵢₙ).

Herein, an inductive coupling relationship between the first canceling coil 4100 (L_{c,ig}) and the second canceling coil 4200 (L_{c,main}) may be different from (that is, opposite to) an inductive coupling relationship between the ignition antenna structure 2100 (L_{ig}) and the maintaining antenna structure 2200 (Lₘₐᵢₙ), and an induced electromotive force may be canceled thereby. For example, when inductive coupling between the ignition antenna structure 2100 (L_{ig}) and the maintaining antenna structure 2200 (Lₘₐᵢₙ) is an additive coupling relationship, inductive coupling between the first canceling coil 4100 (L_{c,ig}) and the second canceling coil 4200 (L_{c,main}) may be a subtractive coupling relationship. When inductive coupling between the ignition antenna structure 2100 (L_{ig}) and the maintaining antenna structure 2200 (Lₘₐᵢₙ) is a subtractive coupling relationship, inductive coupling between the first canceling coil 4100 (L_{c,ig}) and the second canceling coil 4200 (L_{c,main}) may be an additive coupling relationship. Specifically, a principle of canceling an induced electromotive force will be described with reference to FIG. 11(b). FIG. 11(b) shows an equivalent circuit according to mutual inductances M₂ and M_{c} shown in FIG. 11(a).

According to FIG. 11(b), due to mutual inductances M₂ and M_{c}, induced voltages for the ignition antenna structure 2100 (L_{ig}), the maintaining antenna structure 2200 (Lₘₐᵢₙ), the first canceling coil 4100 (L_{c,ig}), and the second canceling coil 4200 (L_{c,main}) are generated, respectively. Herein, the inductive coupling relationship between the first canceling coil 4100 (L_{c,ig}) and the second canceling coil 4200 (L_{c,main}) is different from the inductive coupling relationship between the ignition antenna structure 2100 (L_{ig}) and the maintaining antenna structure 2200 (Lₘₐᵢₙ), a voltage direction of the induced voltage (*jωM_{c}Iₘₐᵢₙ*) of the first canceling coil 4100 (L_{c,ig}) is opposite to a voltage direction of the induced voltage (*jωM*₂*Iₘₐᵢₙ*) of the ignition antenna structure 2100 (L_{ig}). Accordingly, the induced voltage (*jωM*₂*Iₘₐᵢₙ*) is canceled by the induced voltage (*jωM_{c}Iₘₐᵢₙ*). Herein, when M₂ is equal to M_{c}, the induced voltage (*jωM*₂*Iₘₐᵢₙ*) may be completely canceled by the induced voltage (*jωM_{c}Iₘₐᵢₙ*).

Based on the same principle as described above, when the inductive coupling relationships are different, the voltage direction of the induced voltage (*jωM_{c}I_{ig}*) of the second canceling coil 4200 (L_{c,main}) is opposite to the voltage direction of the induced voltage (*jωM*₂*I_{ig}*) of the maintaining antenna structure 2100 (Lₘₐᵢₙ), so that the induced voltage (*jωM*₂*I_{ig}*) is canceled. When M₂ and M_{c} are identical, the induced voltage(*jωM*₂*I_{ig}*) may be completely canceled by the induced voltage (*jωM_{c}Iₘₐᵢₙ*).

In the present specification, a voltage direction may be associated with a direction of current flowing according to the corresponding voltage. For example, when directions of currents flowing according to two respective voltages are opposite to each other, the directions of the two voltages may mean to be opposite to each other. Conversely, when directions of currents flowing according to two respective voltages are the same, the directions of the two voltages may mean to be the same.

In the meantime, in practice, it may be difficult for M₂ and M_{c} to be exactly identical and for the induced voltage (*jωM*₂*Iₘₐᵢₙ*) and the induced voltage (*jωM*₂*I_{ig}*) to be completely canceled. However, the mutual inductances M₂ and M_{c} need to be determined such that the induced voltage (*jωM*₂*Iₘₐᵢₙ*) and the induced voltage (*jωM*₂*I_{ig}*) are sufficiently canceled. For example, determination needs to be made such that the difference between the mutual inductances M₂ and M_{c} is equal to or lower than a second threshold value. In other words, the difference between the mutual inductances M₂ and M_{c} or respective mutual inductance values of M₂ and M_{c} may be determined such that a residual induced voltage (*jωM*₂*I_{ig} - jωM_{c}I_{ig}*) remaining after cancelation by the induced voltage (*jωM_{c}I_{ig}*) and a residual induced voltage (*jωM*₂*Iₘₐᵢₙ* - *jωM_{c}Iₘₐᵢₙ*) remaining after cancelation by the induced voltage (*jωM_{c}Iₘₐᵢₙ*) are sufficiently low values to an extent that it is considered that no abnormality occurs in plasma ignition and maintenance and in the operation of RF generator 1000 or no influence is exerted thereon.

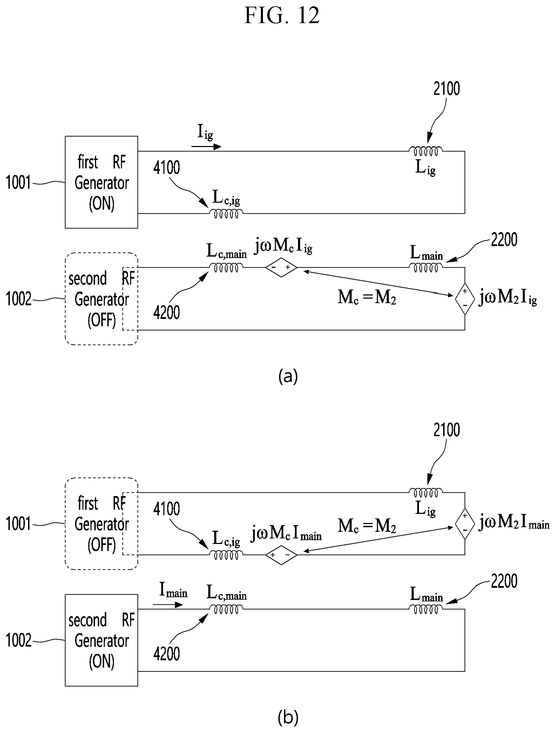

FIG. 12 shows an example in which an induced electromotive force is canceled when only either the first RF generator 1001 or the second RF generator 1002 operates (ON) and the other does not operate (OFF).

As shown in FIG. 12(a), when the first RF generator 1001 is turned on and the second RF generator 1002 is turned off, the current (I_{ig}) flows through the ignition antenna structure 2100 (L_{ig}) and the first canceling coil 4100 (L_{c,ig}) by power supplied from the first RF generator 1001 and the current (Iₘₐᵢₙ) generated by the second RF generator 1002 does not flow through the maintaining antenna structure 2200 (Lₘₐᵢₙ) and the second canceling coil 4200 (L_{c,main}). (However, even in this case, a current such as an induced current may flow through the maintaining antenna structure 2200 (Lₘₐᵢₙ) and the second canceling coil 4200 (L_{c,main}) due to other causes such as the magnetic field generated by the first RF generator 1001.) In this case, an induced electromotive force is generated in each of the maintaining antenna structure 2200 (Lₘₐᵢₙ) and the second canceling coil 4200 (L_{c,main}) by the current (I_{ig}), and the induced voltage (*jωM*₂*I_{ig}*) and the induced voltage (*jωM_{c}I_{ig}*) are generated, respectively. Since positive voltage directions are opposite to each other, the induced voltage (*jωM*₂*I_{g}*) may be canceled by the induced voltage (*jωM_{c}I_{ig}*).

Similarly, as shown in FIG. 12(b), when the second RF generator 1001 is turned on and the first RF generator 1002 is turned off, the current (I_{ig}) does not flow through the ignition antenna structure 2100 (L_{ig}) and the first canceling coil 4100 (L_{c,ig}) and the current (Iₘₐᵢₙ) flows through the maintaining antenna structure 2200 (Lₘₐᵢₙ) and the second canceling coil 4200 (L_{c,main}). In this case, an induced electromotive force is generated in each of the ignition antenna structure 2100 (L_{ig}) and the first canceling coil 4100 (L_{c,ig}) by the current (Iₘₐᵢₙ), and the induced voltage (*jωM*₂*Iₘₐᵢₙ*) and the induced voltage (*jωM_{c}Iₘₐᵢₙ*) are generated, respetively. Since positive voltage directions are opposite to each other, the induced voltage (*jωM*₂*Iₘₐᵢₙ*) may be canceled by the induced voltage (*jωM_{c}Iₘₐᵢₙ*).

Also in the examples shown in FIGS. 12(a) and 12(b), the induced electromotive force (or the induced voltage) is canceled according to the same principle as that described with reference to FIG. 11. Accordingly, even in the cases of the examples shown in FIGS. 12(a) and (b), determination needs to be made such that M₂ and M_{c} are identical or the difference between M₂ and M_{c} is equal to or lower than the second threshold value.

In the meantime, according to the principle described above with reference to FIGS. 11 to 12, the current flowing through the ignition antenna structure 2100 may be determined by the first RF generator 1001 with little or no influence from the current flowing through the maintaining antenna structure 2200. In addition, the current flowing through the maintaining antenna structure 2200 may be determined by the second RF generator 1002 with little or no influence from the current flowing through the ignition antenna structure 2100. Accordingly, the current flowing through the maintaining antenna structure 2200 or the ignition antenna structure 2100 may be independently and precisely adjusted through the canceling coil 4000.

### [Various exemplary configurations of a plasma inducing apparatus for canceling an induced electromotive force according to the present disclosure]

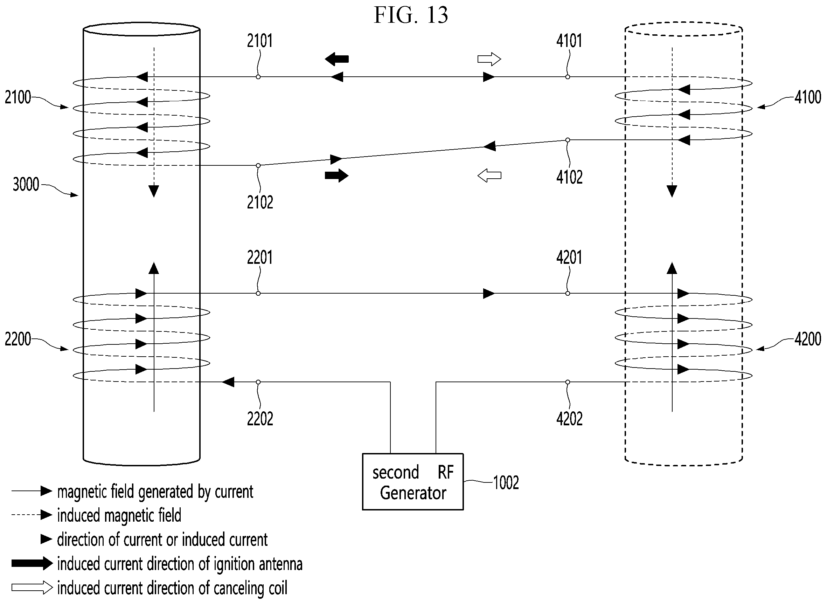

Hereinafter, various exemplary configurations of a plasma inducing apparatus for canceling an induced electromotive force according to the above-described method of canceling an induced electromotive force will be described with reference to FIGS. 13 to 20.

In FIGS. 13 to 20, it is assumed that the second RF generator 1002 is interposed between the maintaining antenna structure 2200 and the second canceling coil 4200 and the second RF generator 1002 applies current to the maintaining antenna structure 2200 and the second canceling coil 4200, and the first RF generator 1001 is interposed between the ignition antenna structure 2100 and the first canceling coil 4100, but does not apply current or voltage. In other words, it is assumed that an induced electromotive force is generated and is canceled in the ignition antenna structure 2100 and the first canceling coil 4100 by the current applied by the second RF generator 1002 to the maintaining antenna structure 2200 and the second canceling coil 4200. In other words, FIGS. 13 to 20 show a canceling process in a state in which the second RF generator 1002 is turned on and the first RF generator 1001 is turned off.

However, a method of canceling an induced electromotive force according to the present disclosure is not limited to eight cases shown in FIGS. 13 to 20. FIGS. 13 to 20 merely show a process of canceling an induced electromotive force according to the winding directions of the ignition antenna structure 2100 and the maintaining antenna structure 2200 and a relationship therebetween and the winding directions of the first canceling coil 4100 and the second canceling coil 4200 and a relationship therebetween.

Accordingly, the present disclosure is not limited to an operation state of a particular RF generator 1001 or 1002 or an interposed position thereof. It will be apparent to those skilled in the art that even when the particular RF generator 1001 or 1002 operates at a position different from that shown in FIGS. 13 to 20 or the two RF generators 1001 and 1002 operate, an induced electromotive force will be canceled in the same manner according to [A method of canceling an induced electromotive force according to an embodiment of the present disclosure] and the principle described with reference to FIGS. 13 to 20. Therefore, even when the first RF generator 1001 is interposed between the ignition antenna structure 2100 and the first canceling coil 4100 and is turned on and the second RF generator 1002 is turned off, or when both the first RF generator 1001 and the second RF generator 1002 are turned on, an induced electromotive force may be canceled according to the same principle described in the present specification, provided that the winding directions of the ignition antenna structure 2100, the maintaining antenna structure 2200, the first canceling coil 4100, and the second canceling coil 4200 are configured to be the same as those shown in FIGS. 13 to 20.

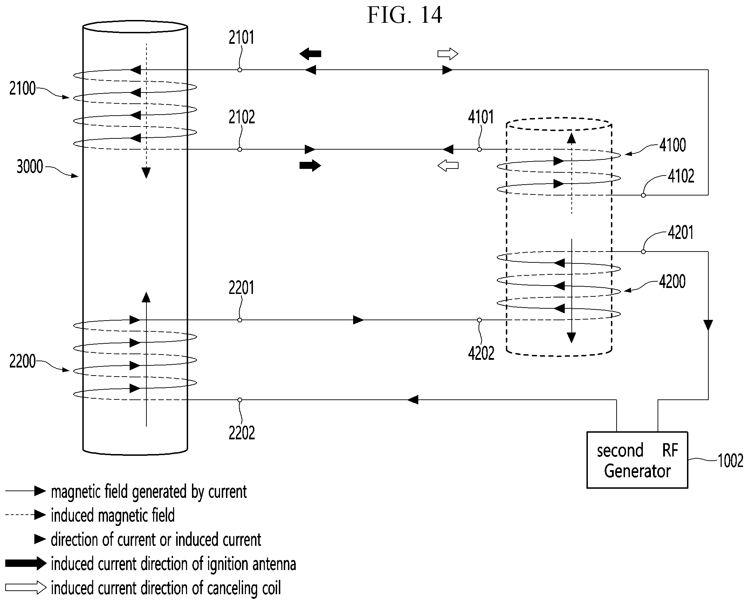

FIG. 13 shows that the winding directions of the ignition antenna structure 2100 and the maintaining antenna structure 2200 are the same and the winding directions of the first canceling coil 4100 and the second canceling coil 4200 are opposite to each other. That is, FIG. 13 shows that the ignition antenna structure 2100, the maintaining antenna structure 2200, and the first canceling coil 4100 are wound in the clockwise direction and the second canceling coil 4200 is wound in the counterclockwise direction. However, the ignition antenna structure 2100 and the maintaining antenna structure 2200 may be wound in the counterclockwise direction, the first canceling coil 4100 may be wound in the counterclockwise direction, and the second canceling coil 4200 may be wound in the clockwise direction. That is, in the method for canceling an induced electromotive force according to the present disclosure, the relationship between the winding directions of the ignition antenna structure 2100 and the maintaining antenna structure 2200 (for example, whether the winding directions are the same) and the relationship between the winding directions of the first canceling coil 4100 and the second canceling coil 4200 (for example, whether the winding directions are the same) are important. As long as the relationships between the winding directions are satisfied, the actual winding directions themselves do not have influence. Accordingly, hereinafter, with reference to FIGS. 14 to 20, a description of the actual winding directions will be omitted, and a description will be provided only with respect to the relationship between the winding directions of the ignition antenna structure 2100 and the maintaining antenna structure 2200 (for example, whether the winding directions are the same) and the relationship between the winding directions of the first canceling coil 4100 and the second canceling coil 4200 (for example, whether the winding directions are the same).

In addition, for convenience of description, the winding direction of the maintaining antenna structure 2200 is referred to as a first winding direction, and the winding direction of the second canceling coil 4200 is referred to as a second winding direction. In addition, the relationship between the winding directions of the ignition antenna structure 2100 and the maintaining antenna structure 2200 is referred to as a first winding direction relationship, and the relationship between the winding directions of the first canceling coil 4100 and the second canceling coil 4200 is referred to as a second winding direction relationship. In addition, in the following description, the term "connected" means "electrically connected," and the term "interposed" means "electrically interposed."

Referring to FIG. 13, the first direction relationship indicates a same-direction relationship, and the second direction relationship indicates a different-direction relationship. In addition, the first end 2101 is connected to the fifth end 4101, and the second end 2102 is connected to the sixth end 4102. That is, the fifth end 4101 is interposed between the first end 2101 and the sixth end 4102, and the sixth end 4102 is interposed between the second end 2102 and the fifth end 4101.

In addition, the third end 2201 is connected to the seventh end 4201, and the fourth end 2202 is connected to the eighth end 4202. That is, the seventh end 4201 is interposed between the third end 2201 and the eighth end 4202, and the eighth end 4202 is interposed between the fourth end 2202 and the seventh end 4201.

According to FIG. 13, depending on the first winding direction and the second winding direction, respective magnetic fields are formed in the maintaining antenna structure 2200 and the second canceling coil 4200 by the current supplied by the second RF generator 1002. Accordingly, an induced magnetic field is formed in the ignition antenna structure 2200 in a direction opposite to the magnetic field formed in the maintaining antenna structure 2200 by the current supplied by the second RF generator 1002, and an induced magnetic field is formed in the first canceling coil 4100 in a direction opposite to the magnetic field formed in the second canceling coil 4200 by the current supplied by the second RF generator 1002. In this case, the direction of the induced current flowing through the ignition antenna structure 2200 and the direction of the induced current flowing through the first canceling coil 4100 are opposite to each other and cancel each other.

Referring to FIG. 14, the first direction relationship indicates a same-direction relationship, and the second direction relationship indicates a different-direction relationship. In addition, the first end 2101 is connected to the sixth end 4102, and the second end 2102 is connected to the fifth end 4101. That is, the fifth end 4101 is interposed between the second end 2102 and the sixth end 4102, and the sixth end 4102 is interposed between the first end 2102 and the fifth end 4101.

In addition, the third end 2201 is connected to the eighth end 4202, and the fourth end 2202 is connected to the seventh end 4201. That is, the seventh end 4201 is interposed between the fourth end 2201 and the eighth end 4202, and the eighth end 4202 is interposed between the third end 2201 and the seventh end 4201.

According to FIG. 14, depending on the first winding direction and the second winding direction, respective magnetic fields are formed in the maintaining antenna structure 2200 and the second canceling coil 4200 by the current supplied by the second RF generator 1002. Accordingly, an induced magnetic field is formed in the ignition antenna structure 2200 in a direction opposite to the magnetic field formed in the maintaining antenna structure 2200 by the current supplied by the second RF generator 1002, and an induced magnetic field is formed in the first canceling coil 4100 in a direction opposite to the magnetic field formed in the second canceling coil 4200 by the current supplied by the second RF generator 1002. In this case, the direction of the induced current flowing through the ignition antenna structure 2200 and the direction of the induced current flowing through the first canceling coil 4100 are opposite to each other and cancel each other.

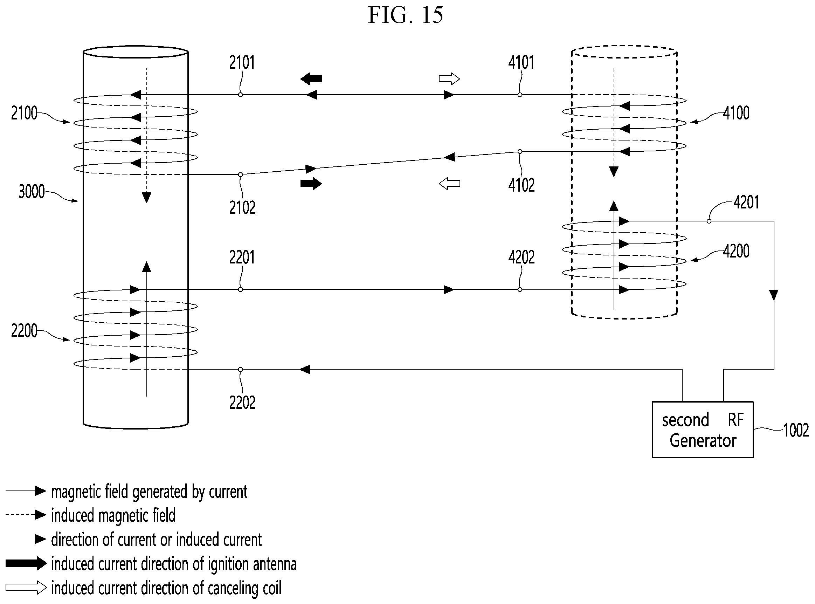

Hereinafter, with reference to FIGS. 15 to 20, connection relationships or interposed relationships among the first end 2101 to the eighth end 4202 will be summarized and described.

That is, as shown in FIG. 13, the first end 2101 is connected to the fifth end 4101, the second end 2102 is connected to the sixth end 4102, the fifth end 4101 is interposed between the first end 2101 and the sixth end 4102, and the sixth end 4102 is interposed between the second end 2102 and the fifth end 4101. This is referred to as a 'first connection relationship'.

In addition, as shown in FIG. 13, the third end 2201 is connected to the seventh end 4201, the fourth end 2202 is connected to the eighth end 4202, the seventh end 4201 is interposed between the third end 2201 and the eighth end 4202, and the eighth end 4202 is interposed between the fourth end 2202 and the seventh end 4201. This is referred to as a 'second connection relationship'.

In addition, as shown in FIG. 14, the first end 2101 is connected to the sixth end 4102, the second end 2102 is connected to the fifth end 4101, the fifth end 4101 is interposed between the second end 2102 and the sixth end 4102, and the sixth end 4102 is interposed between the first end 2102 and the fifth end 4101. This is referred to as a 'third connection relationship'.

In addition, as shown in FIG. 14, the third end 2201 is connected to the eighth end 4202, the fourth end 2202 is connected to the seventh end 4201, the seventh end 4201 is interposed between the fourth end 2201 and the eighth end 4202, and the eighth end 4202 is interposed between the third end 2201 and the seventh end 4201. This is referred to as a 'fourth connection relationship'.

In FIG. 15, both the first direction relationship and the second direction relationship indicate a same-direction relationship, and the first connection relationship and the fourth connection relationship are provided.

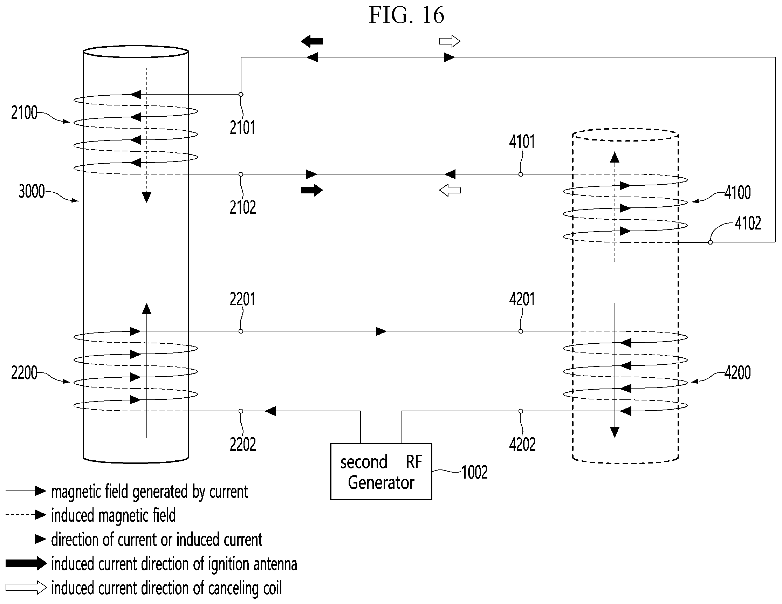

In FIG. 16, both the first direction relationship and the second direction relationship indicate a same-direction relationship, and the second connection relationship and the third connection relationship are provided.

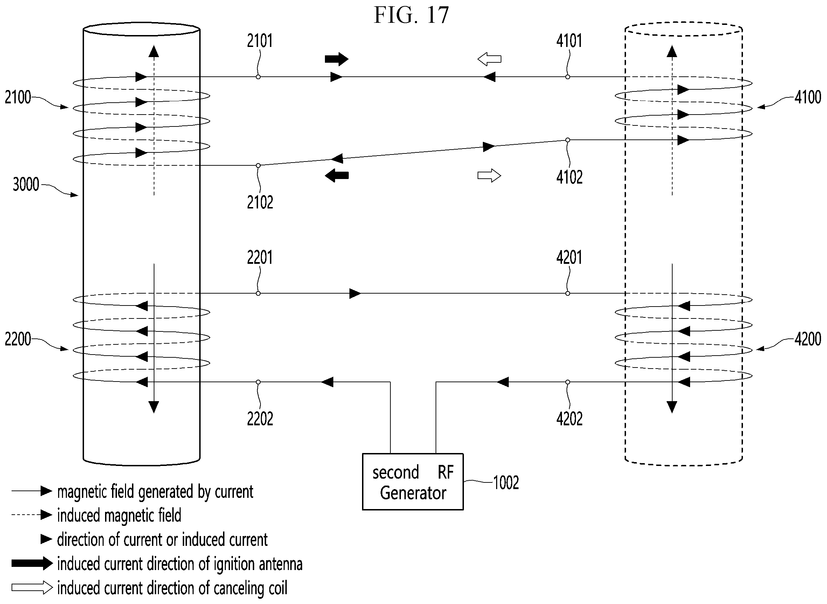

In FIG. 17, the first direction relationship indicates a different-direction relationship, the second direction relationship indicates a same-direction relationship, and the first connection relationship and the third connection relationship are provided.

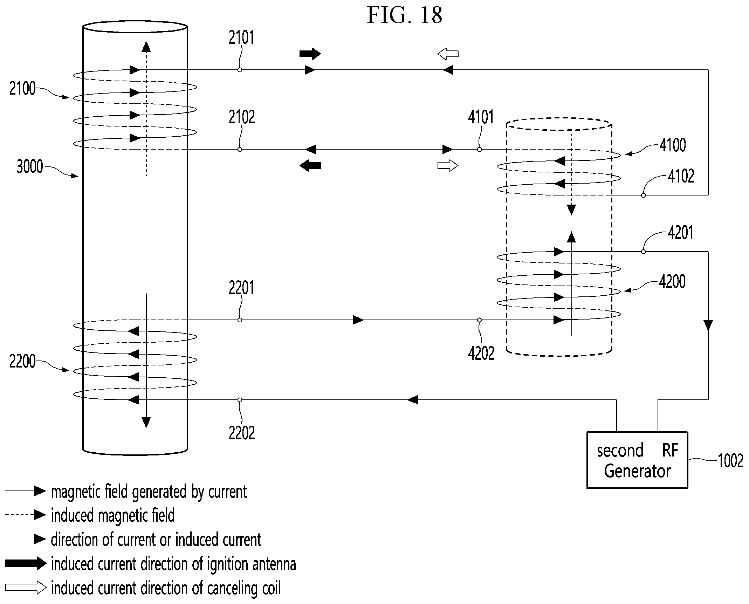

In FIG. 18, the first direction relationship indicates a different-direction relationship, the second direction relationship indicates a same-direction relationship, and the second connection relationship and the fourth connection relationship are provided.

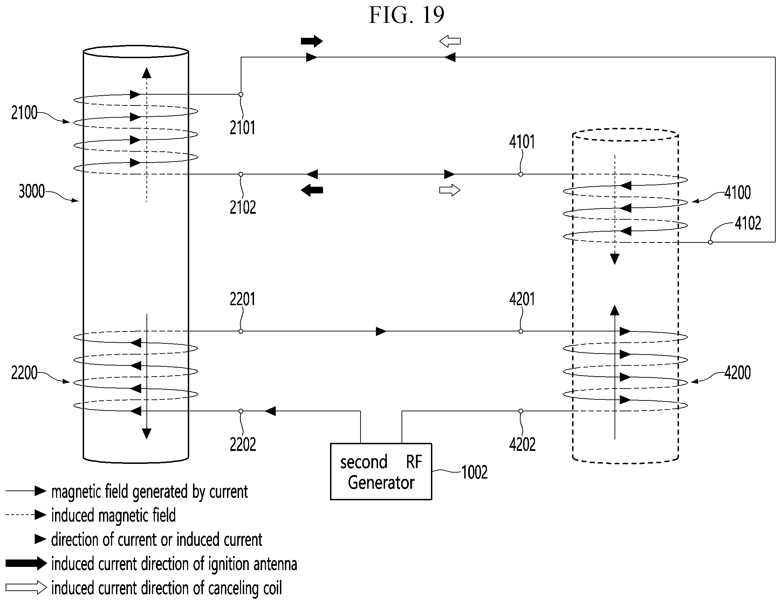

In FIG. 19, both the first direction relationship and the second direction relationship indicate a different-direction relationship, and the second connection relationship and the third connection relationship are provided.

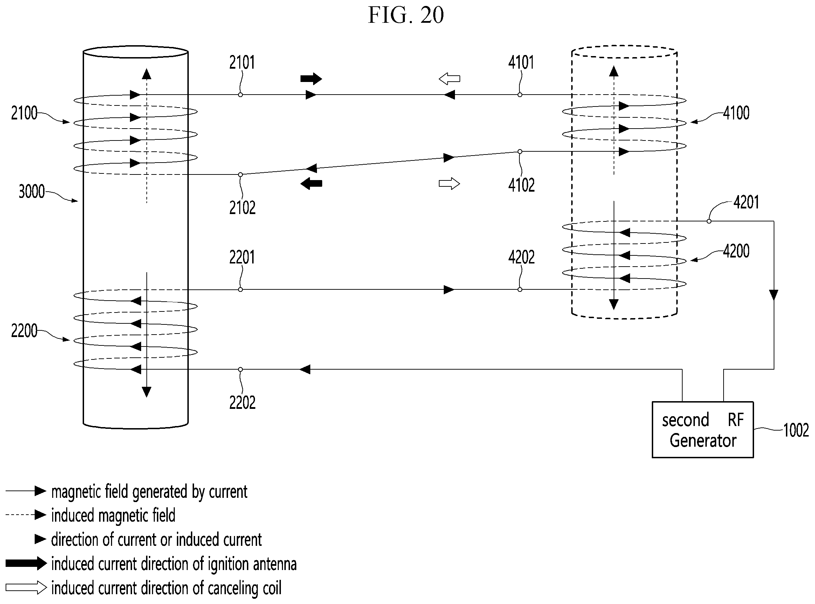

In FIG. 20, both the first direction relationship and the second direction relationship indicate a different-direction relationship, and the first connection relationship and the fourth connection relationship are provided.

According to FIGS. 14 to 20, depending on the first winding direction and the second winding direction, respective magnetic fields are formed in the maintaining antenna structure 2200 and the second canceling coil 4200 by the current supplied by the second RF generator 1002. Accordingly, an induced magnetic field is formed in the ignition antenna structure 2200 in a direction opposite to the magnetic field formed in the maintaining antenna structure 2200 by the current supplied by the second RF generator 1002, and an induced magnetic field is formed in the first canceling coil 4100 in a direction opposite to the magnetic field formed in the second canceling coil 4200 by the current supplied by the second RF generator 1002. In this case, the direction of the induced current flowing through the ignition antenna structure 2200 and the direction of the induced current flowing through the first canceling coil 4100 are opposite to each other and cancel each other.

### [A method of compensating for a resonant frequency varied by a canceling coil 4000 according to the present disclosure]

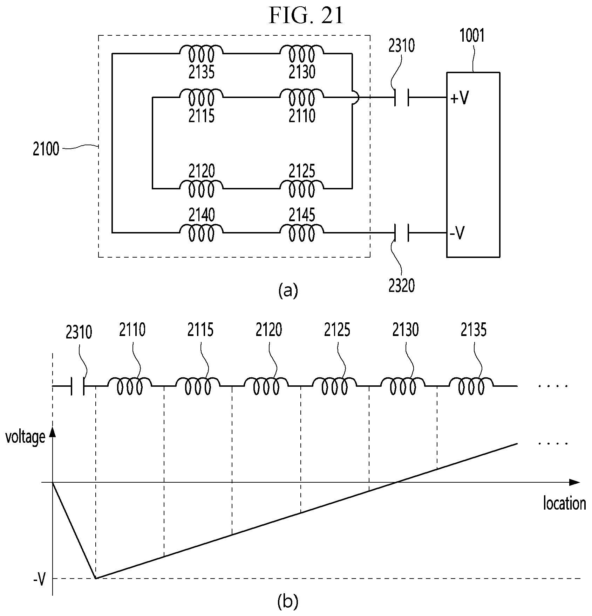

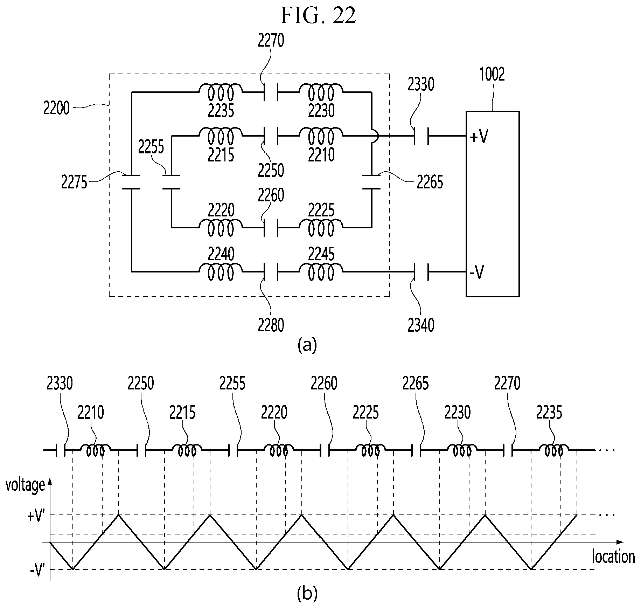

FIG. 21 shows a structure of the ignition antenna structure 2100 and a change in voltage applied to the ignition antenna structure 2100. FIG. 22 shows a structure of the maintaining antenna structure 2200 and a change in voltage applied to the maintaining antenna structure 2200.

FIG. 21(a) shows an example in which the ignition antenna structure 2100 comprises two turns in one layer. However, no limitation thereto is imposed. The ignition antenna structure 2100 may comprise two or more turns and a plurality of layers. An ignition capacitor 2310 or 2320 may be interposed between the first RF generator 1001 and at least one of the both ends of the ignition antenna structure 2100. For example, one of the ignition capacitors 2310 and 2320 may be interposed between the first RF generator 1001 and any one of the both ends of the ignition antenna structure 2100. Alternatively, the ignition capacitors 2310 and 2320 may be respectively interposed between the first RF generator 1001 and each of the both ends of the ignition antenna structure 2100. In addition, ignition antenna segments 2110 to 2145 divided within the ignition antenna structure 2100 may be connected in series but are divided for convenience of description. In practice, the ignition antenna segments may be implemented in the form of one inductor. FIG. 22(b), when voltage is applied to the ignition antenna structure 2100, voltage distribution occurs while passing through the ignition capacitor 2310. Afterward, voltage gradually increases while passing through the inductor, thereby forming a structure advantageous for plasma ignition.

FIG. 22(a) shows an example in which the maintaining antenna structure 2200 comprises two turns in one layer. However, no limitation thereto is imposed. The maintaining antenna structure 2200 may comprise f two or more turns and a plurality of layers. A maintaining capacitor 2330 or 2340 may be interposed between the second RF generator 1002 and at least one of the both ends of the maintaining antenna structure 2200. In addition, a plurality of auxiliary capacitors 2250 to 2280 for voltage distribution may be disposed between maintaining antenna segments 2110 to 2145 divided within the maintaining antenna structure 2200. The plurality of auxiliary capacitors prevent voltage from excessively increasing while passing through the maintaining antenna segments, and allow voltage to be stably distributed, thereby enabling stable maintenance of plasma.

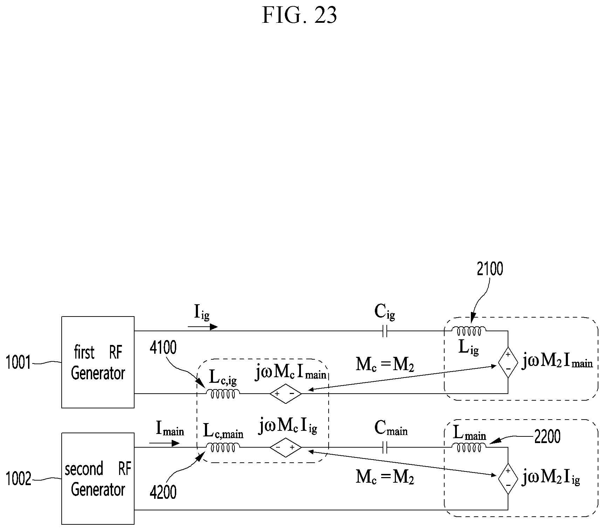

Referring to FIG. 23, C_{ig} denotes a first equivalent capacitor based on the ignition capacitors 2310 and 2320, and Cₘₐᵢₙ denotes a second equivalent capacitor based on the maintaining capacitors 2330 and 2340 and the plurality of auxiliary capacitors 2250 to 2280.

That is, FIG. 23 shows that the first equivalent capacitor (C_{ig}) and the second equivalent capacitor (Cₘₐᵢₙ) are added to the equivalent circuit shown in FIG. 11(b).

A first resonant frequency is determined by capacitance of the first equivalent capacitor and inductance of the ignition antenna structure 2100. Herein, as shown in FIG. 23, when the first canceling coil 4100 is connected in series, the first resonant frequency varies. That is, when the first canceling coil 4100 is connected in series with the ignition antenna structure 2100, an (equivalent) inductance value increases and the first resonant frequency decreases. (see Equation 2) ${ω}_{O} = \frac{1}{\sqrt{LC}}$

Accordingly, when series connection of the first canceling coil 4100 decreases the first resonant frequency, energy that can be provided to the ignition antenna structure 2100 and into the discharging tube 3000 corresponding thereto is reduced when the same voltage is applied to the first RF generator 1001. That is, efficiency of energy provided into the discharging tube 3000 decreases.

Accordingly, for energy efficiency, it is preferable that the resonant frequency does not vary from the first resonant frequency before the first canceling coil 4100 is connected.

For the same reason, a second resonant frequency is determined by inductance of the maintaining antenna structure 2200 and capacitance of the second equivalent capacitor. When the second canceling coil 4200 is connected in series with the maintaining antenna structure 2200, an (equivalent) inductance increases and the second resonant frequency decreases, thereby reducing efficiency of energy that can be provided to the maintaining antenna structure 2200 and into the discharging tube 3000 corresponding thereto. Accordingly, it is preferable that the second resonant frequency does not vary due to the second canceling coil 4200.

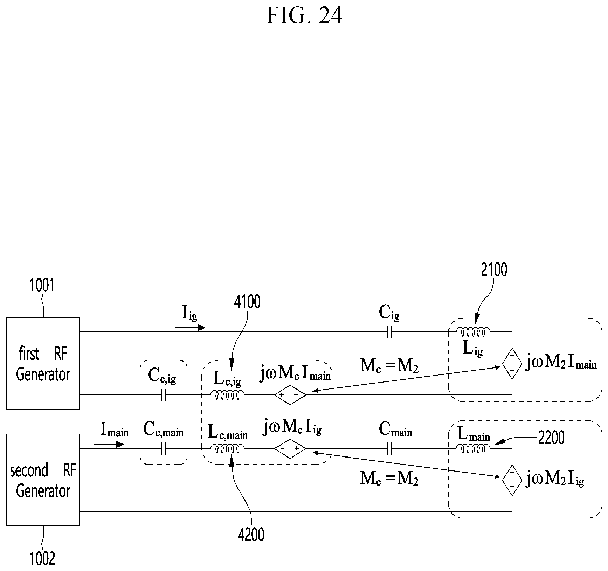

FIG. 24 shows that, for the reasons described above, a first compensation capacitor (C_{c,ig}) and a second compensation capacitor (C_{c,main}) are respectively connected in series with the first canceling coil 4100 (L_{c,ig}) and the second canceling coil 4200 (L_{c,main}) so that the first resonant frequency and the second resonant frequency do not vary.

In order to compensate for a decrease in a resonant frequency caused by an increase in an equivalent inductance value due to the first canceling coil 4100 (L_{c,ig}) and the second canceling coil 4200 (L_{c,main}), an equivalent capacitance value needs to be reduced to increase the resonant frequency again. Accordingly, in order to reduce the equivalent capacitance value, the first compensation capacitor (C_{c,ig}) needs to be electrically connected in series with the first equivalent capacitor (C_{ig}), and the second compensation capacitor (C_{c,main}) needs to be electrically connected in series with the second equivalent capacitor (Cₘₐᵢₙ).

However, in the above-described embodiments according to the present disclosure, the first equivalent capacitor (C_{ig}) is electrically connected in series with the ignition antenna structure 2100 (L_{ig}) and the first canceling coil 4100 (L_{c,ig}), so the first compensation capacitor (C_{c,ig}) needs to be electrically connected in series with the ignition antenna structure 2100 (L_{ig}) and the first canceling coil 4100 (L_{c,ig}). That is, all the first equivalent capacitor (C_{ig}), the ignition antenna structure 2100 (L_{ig}), the first canceling coil 4100 (L_{c,ig}) and the first compensation capacitor (C_{c,ig}) need to be electrically connected in series. In addition, since the first compensation capacitor (C_{c,ig}) only needs to be electrically connected in series with the first equivalent capacitor (C_{ig}), its position is not limited to being interposed between the first canceling coil 4100 (L_{c,ig}) and the first RF generator 1001 as shown in FIG. 24. For example, the first compensation capacitor (C_{c,ig}) only needs to be electrically connected in series with the first equivalent capacitor (C_{ig}), so may be interposed between the first canceling coil 4100 (L_{c,ig}) and the ignition antenna structure 2100 (L_{ig}), or interposed between the ignition antenna structure 2100 (L_{ig}) and the first equivalent capacitor (C_{ig}), or interposed between the first equivalent capacitor (C_{ig}) and the first RF generator 1001.

In the meantime, the first compensation capacitor (C_{c,ig}) prevents the first resonant frequency from varying, and thus needs to reduce the C value by an amount corresponding to an increase in the L value in [Equation 2].

To this end, the first compensation capacitor (C_{c,ig}) may be determined to have a capacitance value that satisfies [Equation 3]. $\frac{1}{\sqrt{{L}_{ig} {C}_{ig}}} = \frac{1}{\sqrt{{L}_{c , ig} {C}_{c , ig}}}$

As a result, the capacitance value of the first compensation capacitor (C_{c,ig}) may be determined by [Equation 4]. ${C}_{c , ig} = \frac{{L}_{ig} {C}_{ig}}{{L}_{c , ig}}$

In the meantime, even when the first compensation capacitor (C_{c,ig}) is added, it may be difficult to maintain the first resonant frequency to be exactly the same due to physical measurement errors. In other words, due to physical measurement errors, it may be difficult to determine the capacitance value of the first compensation capacitor (C_{c,ig}) that maintains the first resonant frequency to be exactly the same.

Accordingly, although the addition of the first canceling coil 4100 (L_{c,ig}) and the first compensation capacitor (C_{c,ig}) causes a difference from the first resonant frequency, a variation of a resonant frequency within an allowable error range may be permitted. In this case, the first compensation capacitor (C_{c,ig}) may be electrically connected in series such that the difference between the first resonant frequency determined by the ignition antenna structure 2100 (L_{ig}) and the first equivalent capacitor (C_{ig}) and a third resonant frequency determined by the first canceling coil 4100 (L_{c,ig}) and the first compensation capacitor (C_{c,ig}) is equal to or lower than a first value.

In addition, in the above-described embodiments according to the present disclosure, the second equivalent capacitor (Cₘₐᵢₙ) is electrically connected in series with the maintaining antenna structure 2200 (Lₘₐᵢₙ) and the second canceling coil 4200 (L_{c,main}), so the second compensation capacitor (C_{c,main}) needs to be electrically connected in series with the maintaining antenna structure 2200 (Lₘₐᵢₙ) and the second canceling coil 2100 (L_{c,main}). That is, all the second equivalent capacitor (Cₘₐᵢₙ), the maintaining antenna structure 2200 (Lₘₐᵢₙ), the second canceling coil 4200 (L_{c,main}), and the second compensation capacitor (C_{c,main}) need to be electrically connected in series. In addition, since the second compensation capacitor (C_{c,main}) merely needs to be electrically connected in series with the second equivalent capacitor (Cₘₐᵢₙ), its position is not limited to being interposed between the second canceling coil 4200 (L_{c,main}) and the second RF generator 1002 as shown in FIG. 24. For example, the second compensation capacitor (C_{c,main}) merely needs to be electrically connected in series with the second equivalent capacitor (Cₘₐᵢₙ), so may be interposed between the second canceling coil 4200 (L_{c,main}) and the maintaining antenna structure 2200 (Lₘₐᵢₙ), or interposed between the maintaining antenna structure 2200 (Lₘₐᵢₙ) and the second equivalent capacitor (Cₘₐᵢₙ), or interposed between the second equivalent capacitor (Cₘₐᵢₙ) and the second RF generator 1002.

In the meantime, the second compensation capacitor (C_{c,main}) prevents the second resonant frequency from varying, and thus needs to reduce the C value by an amount corresponding to an increase in the L value in [Equation 2].

To this end, the second compensation capacitor (C_{c,main}) may be determined to have a capacitance value that satisfies [Equation 5].$\frac{1}{\sqrt{{L}_{main} {C}_{main}}} = \frac{1}{\sqrt{{L}_{c , main} {C}_{c , main}}}$

As a result, the capacitance value of the second compensation capacitor (C_{c,main}) may be determined by [Equation 6]. ${C}_{c , main} = \frac{{L}_{main} {C}_{main}}{{L}_{c , main}}$

In the meantime, even when the second compensation capacitor (C_{c,main}) is added, it may be difficult to maintain the second resonant frequency to be exactly the same due to physical measurement errors. In other words, due to physical measurement errors, it may be difficult to determine the capacitance value of the second compensation capacitor(C_{c,main}) that maintains the second resonant frequency to be exactly the same.

Accordingly, although the addition of the second canceling coil 4200 (L_{c,main}) and the second compensation capacitor (C_{c,main}) causes a difference from the first resonant frequency, a variation of a resonant frequency within an allowable error range may be permitted. In this case, the second compensation capacitor (C_{c,main}) may be electrically connected in series such that the difference between the second resonant frequency determined by the maintaining antenna structure 2200 (Lₘₐᵢₙ) and the second equivalent capacitor (Cₘₐᵢₙ) and a fourth resonant frequency determined by the second canceling coil 4200 (L_{c,main}) and the second compensation capacitor (C_{c,main}) is equal to or lower than a second value.

In the meantime, for convenience of description, although the first compensation capacitor (C_{c,ig}) and the second compensation capacitor (C_{c,main}) are described as each being one capacitor, they may correspond to equivalent capacitors obtained by combining capacitance values of a plurality of compensation capacitors. In other words, regarding the first compensation capacitor (C_{c,ig}) and the second compensation capacitor (C_{c,main}), equivalent capacitors, such as the first equivalent capacitor (C_{ig}) and the second equivalent capacitor (Cₘₐᵢₙ), each having a plurality of compensation capacitances may be represented as the first compensation capacitor (C_{c,ig}) and the second compensation capacitor (C_{c,main}) in FIG. 24. Accordingly, each of the first compensation capacitor (C_{c,ig}) and the second compensation capacitor (C_{c,main}) may comprise at least one compensation capacitor. In the meantime, when each of the first compensation capacitor (C_{c,ig}) and the second compensation capacitor (C_{c,main}) comprises a plurality of compensation capacitors, the first compensation capacitor (C_{c,ig}) and the second compensation capacitor (C_{c,main}) may be defined as a first compensation equivalent capacitor and a second compensation equivalent capacitor, respectively.

In addition, as described above, the first resonant frequency and the second resonant frequency may be the same or different. In addition, the first resonant frequency and the second resonant frequency are not dependent on each other, and one does not affect the other. That is, the first resonant frequency and the second resonant frequency may be independently determined.

In the meantime, although sections have been divided and described in the present specification for convenience of description, the embodiments should not be construed as being distinguished or limited by such divided sections. That is, the present specification discloses [Configuration of a plasma inducing apparatus according to an embodiment of the present disclosure] for solving [Problems in the Related Art] that may arise from the disclosures from [Definition of terms] to [Plasma induction process], and describes a principle of [A method of canceling an induced electromotive force according to an embodiment of the present disclosure] by using the plasma inducing apparatus, and discloses [Various exemplary configurations of a plasma inducing apparatus for canceling an induced electromotive force according to the present disclosure] according to the principle.

In addition, in order to solve additional problems that may arise from [Configuration of a plasma inducing apparatus according to an embodiment of the present disclosure] for solving [Problems in the Related Art], [A method of compensating for a resonant frequency varied by a canceling coil 4000 according to the present disclosure] is disclosed.

In other words, the sections described in the present specification should be understood as being disclosed sequentially and/or in series, rather than the embodiments described in the respective sections being disclosed selectively and/or in parallel, and thus as constituting one implementation, and those skilled in the art will be able to readily understand such an implementation based on the description of the present specification.

Methods according to embodiments of the present disclosure may be implemented in the form of program instructions executable through diverse computing means and may be recorded in computer readable media. The computer-readable media may include, independently or in combination, program instructions, data files, data structures, and so on. Program instructions recorded in the media may be specially designed and configured for the embodiments or may be generally known by those skilled in the computer software art. Computer-readable recording media may include magnetic media such as hard disks, floppy disks, and magnetic tapes, optical media such as a compact disc read only memory (CD-ROM) and a digital versatile disc (DVD), magneto-optical media such as floptical disks, and hardware units, such as a read only memory (ROM), a random access memory (RAM), a flash memory, and so on, which are intentionally formed to store and perform program instructions. Program instructions may include high-class language codes executable by computers using interpreters, as well as machine language codes such as those made by compilers. The hardware units may be configured to function as one or more software modules for performing the operations according to the embodiments of the present disclosure, and vice versa.

While embodiments of the present disclosure have been shown and described with reference to the accompanying drawings thereof, it will be understood by those skilled in the art that various changes and modifications in form and details may be made therein. For example, desired results may be achieved although the embodiments of the present disclosure are performed in other sequences different from the descriptions, and/or the elements, such as a system, a structure, a device, a circuit, and so on, are combined or assembled in other ways different from the descriptions, or replaced or substituted with other elements or their equivalents.

Therefore, other implementations, other embodiments, and equivalents of the appended claims may be included in the scope of the appended claims.

## Claims

1. A plasma inducing apparatus for inducing a plasma, the plasma inducing apparatus comprising:
a discharging tube providing an induction space of the plasma and having an inlet for introducing a gas and an outlet through which the gas is processed and discharged;
an ignition antenna electrically wounded as a first wounding direction with respect to a central axis of the discharging tube and for igniting the plasma within the discharging tube,
wherein the ignition antenna has a first end and a second end, the first end is closer to the inlet to the second end;
a maintaining antenna electrically wounded as the same direction with a first wounding direction with respect to the central axis of the discharging tube, disposed physically spaced apart from the ignition antenna and forming electric field for maintain the plasma within the discharging tube,
wherein the maintaining antenna has a third end and a fourth end, the third end is closer to the second end than the fourth end and the fourth end is closer to the outlet than the third end;
a first canceling coil electrically wounded as a second wounding direction with respect to a virtual central axis,
wherein the first canceling coil has a fifth end and a sixth end, the fifth end is electrically interposed between the first end and the sixth end, and the sixth end is electrically interposed between the second end and the fifth end; and
a second canceling coil electrically wounded as a different direction with the second wounding direction with respect to the virtual central axis, and disposed physically spaced apart from the first canceling coil,
wherein the second canceling coil has a seventh end and an eighth end, the seventh end is electrically interposed between the third end and the eighth end, and the eighth end is electrically interposed between the seventh end and the fourth end.

2. The plasma inducing apparatus of Claim 1, wherein each of the first canceling coil and the second canceling coil has an inductance value allowing that a difference between a first mutual inductance value between the ignition antenna and the maintaining antenna and a second mutual inductance between the first canceling coil and the second canceling coil is equal to or lower than a first threshold value.

3. The plasma inducing apparatus of Claim 1, wherein each of the first canceling coil and the second canceling coil has an inductance value allowing that a first mutual inductance value between the ignition antenna the maintaining antenna is identical to a second mutual inductance between the first canceling coil and the second canceling coil.

4. The plasma inducing apparatus of Claim 1, wherein the first canceling coil and the second canceling coil are physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to or lower than a second threshold value.

5. The plasma inducing apparatus of Claim 1, wherein the first canceling coil and the second canceling coil are physically spaced apart from the discharging tube such that all of a first coupling coefficient between the ignition antenna and the first canceling coil, a second coupling coefficient between the ignition antenna and the second canceling coil, a third coupling coefficient between the maintaining antenna and the first canceling coil and a fourth coupling coefficient between the maintaining antenna and the second canceling coil is equal to 0.

6. The plasma inducing apparatus of Claim 1, further comprising:
a first Radio Frequency (RF) generator electrically interposed between the ignition antenna and the first canceling coil, and configured to supply a first AC voltage to the ignition antenna and the first canceling coil; and
a second RF generator electrically interposed between the maintaining antenna and the second canceling coil, and configured to supply a second AC voltage to the maintaining antenna and the second canceling coil.

7. The plasma inducing apparatus of Claim 6, further comprising:
a first equivalent capacitor, wherein the first equivalent capacitor is determined by at least one ignition capacitor interposed between the first RF generator and the ignition antenna; and
a first compensation capacitor, wherein the first compensation capacitor is interposed between the ignition antenna and the first canceling coil,
wherein the capacitance value of the first compensation capacitor allows that a difference between a first resonant frequency according to the ignition antenna and the first equivalent capacitor and a second resonant frequency according to the first canceling coil and the first compensation capacitor is equal to or lower than a first value.

8. The plasma inducing apparatus of Claim 6, further comprising:
a first equivalent capacitor, wherein the first equivalent capacitor is determined by at least one ignition capacitor interposed between the first RF generator and the ignition antenna; and
a first compensation capacitor, wherein the first compensation capacitor is interposed between the ignition antenna and the first canceling coil,
wherein the capacitance value of the first compensation capacitor allows that a first resonant frequency according to the ignition antenna and the first equivalent capacitor is identical to a second resonant frequency according to the first canceling coil and the first compensation capacitor.

9. The plasma inducing apparatus of Claim 6, further comprising:
a second equivalent capacitor, wherein the second equivalent capacitor is determined by at least one maintaining capacitor interposed between the second RF generator and the maintaining antenna and at least one auxiliary capacitor included within the maintaining antenna; and
a second compensation capacitor interposed between the maintaining antenna and the second canceling coil,
wherein the capacitance value of the second compensation capacitor allows that a difference between a third resonant frequency according to the maintaining antenna and the second equivalent capacitor and a fourth resonant frequency according to the second canceling coil and the second compensation capacitor is equal to or lower than a second value.

10. The plasma inducing apparatus of Claim 6, further comprising:
a second equivalent capacitor, wherein the second equivalent capacitor is determined by at least one maintaining capacitor interposed between the second RF generator and the maintaining antenna and at least one auxiliary capacitor included within the maintaining antenna; and
a second compensation capacitor interposed between the maintaining antenna and the second canceling coil,
wherein the capacitance value of the second compensation capacitor allows that a third resonant frequency according to the maintaining antenna and the second equivalent capacitor is identical to a fourth resonant frequency according to the second canceling coil and the second compensation capacitor is equal to or lower than a second value.

11. The plasma inducing apparatus of Claim 6, wherein the plasma inducing apparatus is configured to control the second RF generator not to supply the second AC voltage while controlling the first RF generator to supply the first AC voltage, or
configured to control the first RF generator not to supply the first AC voltage while controlling the second RF generator to supply the second AC voltage.

12. The plasma inducing apparatus of Claim 6, wherein the plasma inducing apparatus is configured to control the second RF generator to supply the second AC voltage while controlling the first RF generator to supply the first AC voltage.

13. A plasma inducing apparatus for inducing a plasma, the plasma inducing apparatus comprising:
a discharging tube providing an induction space of the plasma and having an inlet for introducing a gas and an outlet through which the gas is processed and discharged;
an ignition antenna electrically wounded as a first wounding direction with respect to a central axis of the discharging tube and for igniting the plasma within the discharging tube,
wherein the ignition antenna has a first end and a second end, the first end is closer to the inlet to the second end;
a maintaining antenna electrically wounded as the same direction with a first wounding direction with respect to the central axis of the discharging tube, disposed physically spaced apart from the ignition antenna and forming electric field for maintain the plasma within the discharging tube,
wherein the maintaining antenna has a third end and a fourth end, the third end is closer to the second end than the fourth end and the fourth end is closer to the outlet than the third end;
a first canceling coil electrically wounded as a second wounding direction with respect to a virtual central axis,
wherein the first canceling coil has a fifth end and a sixth end, the fifth end is electrically interposed between the first end and the sixth end, and the sixth end is electrically interposed between the second end and the fifth end; and
a second canceling coil electrically wounded as the same direction with the second wounding direction with respect to the virtual central axis, and disposed physically spaced apart from the first canceling coil,
wherein the second canceling coil has a seventh end and an eighth end, the seventh end is electrically interposed between the fourth end and the eighth end, and the eighth end is electrically interposed between the seventh end and the third end.

14. A plasma inducing apparatus for inducing a plasma, the plasma inducing apparatus comprising:
a discharging tube providing an induction space of the plasma and having an inlet for introducing a gas and an outlet through which the gas is processed and discharged;
an ignition antenna electrically wounded as a first wounding direction with respect to a central axis of the discharging tube and for igniting the plasma within the discharging tube,
wherein the ignition antenna has a first end and a second end, the first end is closer to the inlet to the second end;
a maintaining antenna electrically wounded as the same direction with a first wounding direction with respect to the central axis of the discharging tube, disposed physically spaced apart from the ignition antenna and forming electric field for maintain the plasma within the discharging tube,
wherein the maintaining antenna has a third end and a fourth end, the third end is closer to the second end than the fourth end and the fourth end is closer to the outlet than the third end;
a first canceling coil electrically wounded as a second wounding direction with respect to a virtual central axis,
wherein the first canceling coil has a fifth end and a sixth end, the fifth end is electrically interposed between the second end and the sixth end, and the sixth end is electrically interposed between the first end and the fifth end; and
a second canceling coil electrically wounded as a different direction with the second wounding direction with respect to the virtual central axis, and disposed physically spaced apart from the first canceling coil,
wherein the second canceling coil has a seventh end and an eighth end, the seventh end is electrically interposed between the fourth end and the eighth end, and the eighth end is electrically interposed between the seventh end and the third end.

15. A plasma inducing apparatus for inducing a plasma, the plasma inducing apparatus comprising:
a discharging tube providing an induction space of the plasma and having an inlet for introducing a gas and an outlet through which the gas is processed and discharged;
an ignition antenna electrically wounded as a first wounding direction with respect to a central axis of the discharging tube and for igniting the plasma within the discharging tube,
wherein the ignition antenna has a first end and a second end, the first end is closer to the inlet to the second end;
a maintaining antenna electrically wounded as the same direction with a first wounding direction with respect to the central axis of the discharging tube, disposed physically spaced apart from the ignition antenna and forming electric field for maintain the plasma within the discharging tube,
wherein the maintaining antenna has a third end and a fourth end, the third end is closer to the second end than the fourth end and the fourth end is closer to the outlet than the third end;
a first canceling coil electrically wounded as a second wounding direction with respect to a virtual central axis,
wherein the first canceling coil has a fifth end and a sixth end, the fifth end is electrically interposed between the second end and the sixth end, and the sixth end is electrically interposed between the first end and the fifth end; and
a second canceling coil electrically wounded as the same direction with the second wounding direction with respect to the virtual central axis, and disposed physically spaced apart from the first canceling coil,
wherein the second canceling coil has a seventh end and an eighth end, the seventh end is electrically interposed between the third end and the eighth end, and the eighth end is electrically interposed between the seventh end and the fourth end.
